# EUROPEAN PATENT SPECIFICATION

(11) **EP 1 060 143 B1**
(45) Date of publication and mention of the grant of the patent: **05.12.2001**
(21) Application number: 99908440.3
(22) Date of filing: 25.02.1999
(51) Int. Cl.: C03C 25/10, C08J 5/08, H05K 1/03

(54) **METHODS FOR INHIBITING ABRASIVE WEAR OF GLASS FIBER STRANDS**
VERFAHREN ZUR HEMMUNG DES VERSCHLEISSES VON GLASSPINNFÄDEN
PROCEDES PERMETTANT D'EMPECHER L'ABRASION DES BRINS DE FIBRES DE VERRE

(30) Priority: 03.03.1998 US 34078; 13.10.1998 US 170579
(43) Date of publication of application: 20.12.2000
(73) Proprietor: PPG Industries Ohio, Inc., Cleveland, OH 44111 (US)
(72) Inventor: NOVICH, Bruce, Barrington, Rhode Island 02806 (US); ROBERTSON, Walter, J., Pittsburgh, PA 15202 (US); WU, Xiang, Littleton, Colorado 80122 (US)
(74) Representative: Sternagel, Fleischer, Godemeyer & Partner Patentanwälte
(86) International application number: US9904060
(87) International publication number: WO9944958

(56) References cited:
- WO-A-90/01860
- WO-A-96/39364
- US-A- 3 312 569
- US-A- 5 217 778
- DATABASE WPI Section Ch, Week 9706 Derwent Publications Ltd., London, GB; Class A85, AN 97-060830 XP002106571 & JP 08 309928 A (HITACHI CHEM CO LTD) , 26 November 1996
- DATABASE WPI Section Ch, Week 9728 Derwent Publications Ltd., London, GB; Class A18, AN 97-306602 XP002106572 & JP 09 118759 A (MATSUSHITA ELECTRIC WORKS LTD), 6 May 1997
- PATENT ABSTRACTS OF JAPAN vol. 014, no. 423 (C-0757), 12 September 1990 & JP 02 160944 A (NITTO BOSEKI CO LTD), 20 June 1990
- DATABASE INSPEC INSTITUTE OF ELECTRICAL ENGINEERS, STEVENAGE, GB Inspec No. 6242125, NOVICH B E: "Hybon RCY yarns: a laminate reinforcement developed for printed circuit boards" XP002106570 & CIRCUITREE, MARCH 1999, CIRCUITREE, USA, vol. 12, no. 3, page 44, 46, 51 ISSN 1059-843X

## Description

### Cross Reference to Related Applications

This patent application is a continuation-in-part application of U.S. Serial No. 09/034,078 of B. Novich et al. entitled "Methods for Inhibiting Abrasive Wear of Glass Fiber Strands" filed March 3, 1998.

This patent application is related to U.S. Patent Application Serial No. of B. Novich et al. entitled "Inorganic Lubricant-Coated Glass Fiber Strands and Products Including the Same", which is a continuation-in-part application of U.S. Application Serial No. 09/034,525 filed March 3, 1998; U.S. Patent Application Serial No. of B. Novich et al. entitled "Glass Fiber Strands Coated With Thermally Conductive Inorganic Solid Particles and Products Including the Same", which is a continuation-in-part application of U.S. Application Serial No. 09/034,663 filed March 3, 1998; U.S. Patent Application Serial No. of B. Novich et al. entitled "Impregnated Glass Fiber Strands and Products Including the Same", which is a continuation-in-part application of U.S. Application Serial No. 09/034,077 filed March 3, 1998; U.S. Patent Application Serial No. of B. Novich et al. entitled "Inorganic Particle-Coated Glass Fiber Strands and Products Including the Same", which is a continuation-in-part application of U.S. Application Serial No. 09/034,056 filed March 3, 1998; and U.S. Patent Application Serial No of B. Novich et al. entitled "Glass Fiber-Reinforced Laminates, Electronic Circuit Boards and Methods for Assembling a Fabric", which is a continuation-in-part application of U.S. Application Serial No. 09/130,270 filed August 6, 1998, each of which has been filed concurrently with the present application.

### Field of the Invention

This invention relates generally to methods for inhibiting abrasion of glass fiber strands and, more specifically, to coating the glass fiber strands with inorganic solid lubricant particles to inhibit abrasion during processing.

### Background of the Invention

Typically, the surfaces of glass fibers are coated with a sizing composition in the forming process to protect the fibers from abrasion during subsequent processing. For example, starch and oil-based sizing compositions are used to protect fibers from interfilament and equipment abrasion during weaving which can contribute to fiber breakage. Other organic lubricants, such as alkyl imidazoline derivatives and amide substituted polyethylene imines, have been added to sizing compositions to reduce abrasion. However, such organic lubricants can deteriorate during subsequent processing or cause undesirable side reactions with other sizing and matrix material components and, as is the case for woven fabric for printed circuit board applications, often must be removed by heat cleaning before laminating to improve compatibility with the polymeric matrix material.

An inert lubricant for inhibiting abrasion of glass fibers which does not appreciably deteriorate during processing and which is compatible with polymeric matrix materials is desirable. However, use of inorganic materials has mainly focused on fillers for modifying general physical characteristics of composites rather than improving abrasion-resistance characteristics of reinforcement fibers.

For example, to dissipate thermal energy, U.S. Patent No. 4,869,954 discloses a sheet-like, thermally conductive material formed of a urethane binder, curing agent and thermally conductive fillers such as aluminum oxide, aluminum nitride, boron nitride, magnesium oxide and zinc oxide and various metals (see col. 2, lines 62-65 and col. 4, lines 3-10). One or more layers of a support material, such as glass fiber cloth, can be included in the thermally conductive material.

To improve penetration of resin between glass reinforcement fibers during formation of a composite, U.S. Patent No. 3,312,569 discloses adhering particles of alumina to the surfaces of the glass fibers and Japanese Patent Application No. 9-208,268 discloses a cloth having yarn formed from glass fibers coated immediately after spinning with starch or a synthetic resin and 0.001 - 20.0 weight percent of inorganic solid particles such as colloidal silica, calcium carbonate, kaolin and talc. However, the Mohs' hardness values of alumina and silica are greater than about 9 and about 7¹, respectively, which can cause abrasion of softer glass fibers.
¹ See R. Weast (Ed.), Handbook of Chemistry and Physics, CRC Press (1975) at page F-22 and H. Katz et al. (Ed.). Handbook of Fillers and Plastics (1987) at page 28, which are hereby incorporated by reference.

U.S. Patent No. 5,541,238 discloses a fiber for reinforcing thermoplastic or thermoset composites which is coated by vapor deposition or plasma process with a single layer of an ultrafine material such as inorganic oxides, nitrides, carbides, borides, metals and combinations thereof having an average particle diameter of 0.005-1 micrometer. Limited space and environmental considerations make the use of vapor deposition or plasma processes under a glass fiber production bushing impractical.

Soviet Union No. 859400 discloses an impregnating composition for manufacturing laminates of glass fiber cloth, the composition containing an alcoholic solution of phenol-formaldehyde resin, graphite, molybdenum disulphide, polyvinyl butyral and surfactant. Volatile alcoholic solvents are not desirable for glass fiber production applications.

To enhance, reduce or modify frictional characteristics of a composite, U.S. Patent No. 5,217,778 discloses a dry clutch facing including a composite yarn of glass fibers, metallic wire and polyacrylonitrile fibers which are impregnated and coated with a heat curable cement or binder system. The binder can include friction particles such as carbon black, graphite, metal oxides, barium sulfate, aluminum silicate, ground rubber particles, ground organic resins, polymerized cashew nut oil, clay, silica or cryolite (see col. 2, lines 55-66).

There is a need to inhibit abrasion and breakage of glass fibers to improve processability in forming and subsequent processing operations to improve efficiency and reduce cost and waste.

### Summary of the Invention

The present invention provides a method for inhibiting abrasive wear of a glass fiber strand comprising at least one glass fiber by sliding contact with surface asperities of a solid object, comprising the steps of: (a) applying a primary layer of an aqueous sizing composition comprising a polymeric material and inorganic solid lubricant particles to at least a portion of a surface of at least one glass fiber of a glass fiber strand; (b) at least partially drying the aqueous sizing composition of the primary layer to form a sized glass fiber strand having a generally uniform coating of the aqueous sizing composition upon the portion of the surface of the at least one glass fiber; and (c) sliding at least a portion of the glass fiber strand to contact surface asperities of a solid object, the surface asperities having a hardness value which is greater than a hardness value of the at least one glass fiber, such that abrasive wear of the at least one glass fiber of the glass fiber strand by contact with the surface asperities of the solid object is inhibited by the inorganic solid lubricant particles.

Another aspect of the present invention is a method for inhibiting abrasive wear of a glass fiber strand comprising at least one glass fiber by sliding contact with surface asperities of a solid object, comprising the steps of: (a) applying a primary layer of an aqueous sizing composition comprising lamellar boron nitride particles, thermosetting polyester film-forming material, polyvinyl pyrrolidone and an epoxy-functional organo silane coupling agent to at least a portion of a surface of the at least one glass fiber of the glass fiber strand; (b) at least partially drying the aqueous sizing composition of the primary layer to form a sized glass fiber strand having a generally uniform coating of the aqueous sizing composition upon the portion of the surface of the at least one glass fiber; and (c) sliding at least a portion of the glass fiber strand to contact surface asperities of a solid object, the surface asperities having a hardness value which is greater than a hardness value of the at least one glass fiber, such that abrasive wear of the at least one glass fiber of the glass fiber strand by contact with the surface asperities of the solid object is inhibited by the inorganic solid lubricant particles.

Yet another aspect of the present invention is a method for inhibiting abrasive wear of a glass fiber strand comprising at least one glass fiber by sliding contact with surface asperities of a solid object, comprising the steps of: (a) applying a primary layer of an aqueous sizing composition comprising a glass fiber coupling agent and inorganic solid lubricant particles to at least a portion of a surface of at least one glass fiber of a glass fiber strand; (b) at least partially drying the aqueous sizing composition of the primary layer to form a sized glass fiber strand having a generally uniform coating of the aqueous sizing composition upon the portion of the surface of the at least one glass fiber; and (c) sliding at least a portion of the glass fiber strand to contact surface asperities of a solid object, the surface asperities having a hardness value which is greater than a hardness value of the at least one glass fiber, such that abrasive wear of the at least one glass fiber of the glass fiber strand by contact with the surface asperities of the solid object is inhibited by the inorganic solid lubricant particles.

Another aspect of the present invention is a method for inhibiting abrasive wear of a glass fiber strand comprising at least one glass fiber by sliding contact with surface asperities of a solid object, comprising the steps of: (a) applying a principal layer of an aqueous secondary coating composition comprising a polymeric film-forming material and inorganic solid lubricant particles to at least a portion of sized surfaces of at least one glass fiber of a glass fiber strand; and (b) sliding at least a portion of the glass fiber strand to contact surface asperities of a solid object, the surface asperities having a hardness value which is greater than a hardness value of the at least one glass fiber, such that abrasive wear of the at least one glass fiber of the glass fiber strand by contact with the surface asperities of the solid object is inhibited by the inorganic solid lubricant particles.

Yet another aspect of the present invention is a method for inhibiting abrasive wear of a glass fiber strand comprising at least one sized and secondarily coated glass fiber by sliding contact with surface asperities of a solid object, comprising the steps of: (a) applying a principal layer comprising powdered non-hydratable, lamellar inorganic solid lubricant particles to at least a portion of a sized and secondarily coated surface of at least one glass fiber of a glass fiber strand; and (b) sliding at least a portion of the glass fiber strand to contact surface asperities of a solid object, the surface asperities having a hardness value which is greater than a hardness value of the at least one glass fiber, such that abrasive wear of the at least one glass fiber of the glass fiber strand by contact with the surface asperities of the solid object is inhibited by the inorganic solid lubricant particles.

Another aspect of the present invention is a method for assembling a fabric by (a) slidingly contacting at least a portion of a first glass fiber strand with surface asperities of a portion of a fabric assembly device, the surface asperities having a hardness value which is greater than a hardness value of glass fibers of the first glass fiber strand; and (b) interweaving the first glass fiber strand with a second fiber strand to form a fabric, wherein the improvement comprises: the first fiber strand comprising a plurality of glass fibers having on at least a portion of surfaces thereof a primary layer of a dried residue of an aqueous sizing composition comprising a polymeric material and inorganic solid lubricant particles which inhibit abrasive wear of the surfaces of the plurality of glass fibers in sliding contact with the surface asperities of the portion of the fabric assembly device.

### Brief Description of the Drawings

The foregoing summary, as well as the following detailed description of the preferred embodiments, will be better understood when read in conjunction with the appended drawings. In the drawings:
Fig. 1 is a perspective view of a coated fiber strand having a primary layer of a dried residue of an aqueous sizing composition according to the present invention;
Fig. 2 is a perspective view of a coated fiber strand having a primary layer of a dried residue of a sizing composition and thereupon a secondary layer of an aqueous secondary coating composition according to the present invention;
Fig. 3 is a perspective view of a coated fiber strand having a primary layer of a dried residue of a sizing composition, a secondary layer of an aqueous secondary coating composition, and a tertiary layer thereupon according to the present invention;
Fig. 4 is a perspective view of a fabric assembly apparatus and fabric according to the present invention; and
Fig. 5 is a cross-sectional view of an electronic support according to the present invention.

### Detailed Description of the Invention

The methods of the present invention relate to inhibiting abrasive wear of glass fiber strands from contact with other solid objects, such as portions of a winding, weaving or knitting device, or by interfilament abrasion. The glass fiber strands of the present invention have a unique coating which not only can inhibit abrasion and breakage of the glass fibers but can provide good laminate strength, good thermal stability, good hydrolytic stability, low corrosion and reactivity in the presence of high humidity, reactive acids and alkalis and compatibility with a variety of polymeric matrix materials, which can eliminate the need for heat cleaning prior to lamination.

Another significant advantage of the coated glass fiber strands of the present invention is good processability in weaving and knitting. Low fuzz and halos, low broken filaments, low strand tension, high fliability and low insertion time are characteristics which can be provided by the coated glass fiber strands of the present invention to facilitate weaving and knitting and consistently provide a fabric with few surface defects for printed circuit board applications.

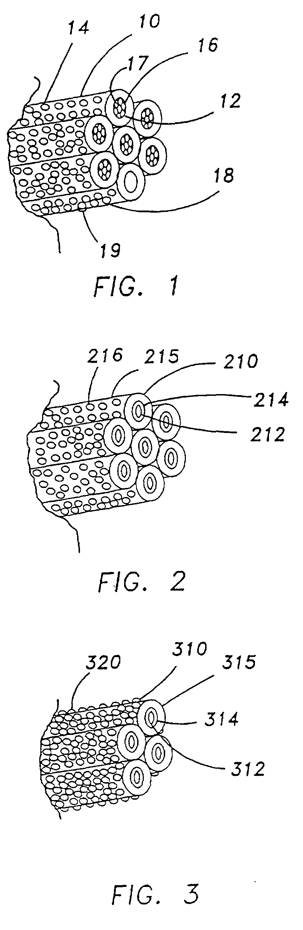

Referring now to Fig. 1, wherein like numerals indicate like elements throughout, there is shown in Fig. 1 a coated fiber strand 10 comprising at least one glass fiber 12, which is useful in preferred methods of the present invention. Preferably the strand 10 comprises a plurality of glass fibers 12. As used herein, the term "strand" means one or more individual fibers. The term "fiber" means an individual filament.

The glass fibers 12 can be formed from any type of fiberizable glass composition known to those skilled in the art, including those prepared from fiberizable glass compositions such as "E-glass", "A-glass", "C-glass", "D-glass", "R-glass", "S-glass", and E-glass derivatives. As used herein, "E-glass derivatives" means glass compositions which include minor amounts of fluorine and/or boron and preferably are fluorine-free and/or boron-free. Furthermore, as used herein, minor means less than about 1 weight percent fluorine and less than about 5 weight percent boron.. Basalt and mineral wool fibers are examples of other glass fibers useful in the present invention. Preferred glass fibers are formed from E-glass or E-glass derivatives. Such compositions and methods of making glass filaments therefrom are well known to those skilled in the art and further discussion thereof is not believed to be necessary in view of the present disclosure. If additional information is needed, such glass compositions and fiberization methods are disclosed in K. Loewenstein, The Manufacturing Technology of Glass Fibres, (3d Ed. 1993) at pages 30-44, 47-60, 115-122 and 126-135, and U.S. Patent Nos. 4,542,106 and 5,789,329, which are hereby incorporated by reference.

In addition to glass fibers, the coated fiber strand 10 can further comprise fibers formed from other fiberizable natural or man-made materials, such as non-glass inorganic materials, natural materials, organic polymeric materials and combinations thereof. As used herein, the term "fiberizable" means a material capable of being formed into a generally continuous filament, fiber, strand or yarn.

Suitable non-glass inorganic fibers include ceramic fibers formed from silicon carbide, carbon, graphite, mullite, aluminum oxide and piezoelectric ceramic materials. Non-limiting examples of suitable animal and vegetable-derived natural fibers include cotton, cellulose, natural rubber, flax, ramie, hemp, sisal and wool. Suitable man-made fibers include those formed from polyamides (such as nylon and aramids), thermoplastic polyesters (such as polyethylene terephthalate and polybutylene terephthalate), acrylics (such as polyacrylonitriles), polyolefins, polyurethanes and vinyl polymers (such as polyvinyl alcohol). Non-glass fibers believed to be useful in the present invention and methods for preparing and processing such fibers are discussed at length in the Encyclopedia of Polymer Science and Technology, Vol. 6 (1967) at pages 505-712, which is hereby incorporated by reference. It is understood that blends or copolymers of any of the above materials and combinations of fibers formed from any of the above materials can be used in the present invention, if desired.

The present invention will now be discussed generally in the context of processing glass fiber strand, although one skilled in the art would understand that the strand 10 can additionally include one or more of the non-glass fibers discussed above.

In a preferred method of the present invention, fibers 12 of fiber strand 10 of the present invention are coated with a primary layer 14 of an aqueous sizing composition on at least a portion 17 of the surface 16 of the fiber 12 to protect the fiber surface 16 from abrasion during processing and inhibit breakage of the fiber 12. Preferably the dried residue of an aqueous sizing composition is applied to the entire outer surface 16 or periphery of the fiber 12.

As used herein, in a preferred embodiment the terms "size", "sized" or "sizing" refer to the coating composition applied to the fibers immediately after formation of the fibers. In an alternative embodiment, the terms "size", "sized" or "sizing" additionally refer to a coating composition (also known as a "finishing size") applied to the fibers after a conventional primary coating composition has been removed by heat or chemical treatment, i.e., the finishing size is applied to bare glass fibers incorporated into a fabric form.

The aqueous sizing composition comprises one or more, and preferably a plurality of, inorganic solid lubricant particles 18. As used herein, "solid lubricant" means that the particles 18 have a characteristic crystalline habit which causes them to shear into thin, flat plates which readily slide over one another and thus produce an antifriction lubricating effect between the glass fiber surface and an adjacent solid surface, at least one of which is in motion. (See R. Lewis, Sr., Hawley's Condensed Chemical Dictionary, (12th Ed. 1993) at page 712, which is hereby incorporated by reference.) Friction is the resistance to sliding one solid over another. (See F. Clauss, Solid Lubricants and Self-Lubricating Solids, (1972) at page 1, which is hereby incorporated by reference.) Glass fibers are subject to abrasive wear by contact with asperities of adjacent glass fibers and/or other solid objects or materials which the glass fibers contact during forming and subsequent processing, such as weaving. "Abrasive wear", as used herein, means scraping or cutting off of bits of the glass fiber surface or breakage of glass fibers by frictional contact with particles, edges or entities (asperities) of materials which are hard enough to produce damage to the glass fibers. (See K. Ludema, Friction, Wear, Lubrication, (1996) at page 129, which is hereby incorporated by reference.)

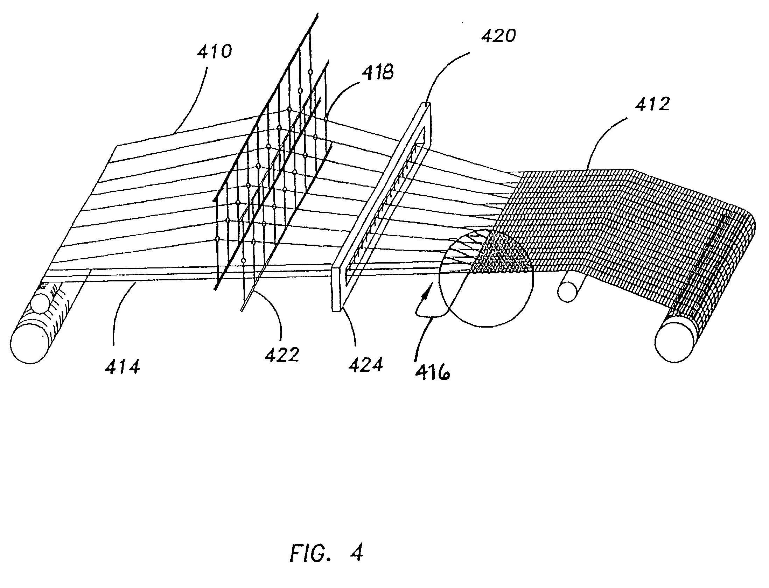

In forming, for example, glass fibers contact solid objects such as a metallic gathering shoe and a traverse or spiral before being wound into a forming package. In fabric assembly operations, such as knitting or weaving, the glass fiber strand contacts solid objects such as portions of the fiber assembly apparatus 420 shown in Fig. 4 (e.g. a loom or knitting device) which can abrade the surfaces 16 of the contacting glass fibers 12. Examples of portions of a loom which contact the glass fibers include air jets and shuttles. Surface asperities of these solid objects which have a hardness value greater than that of the glass fibers can cause abrasive wear of the glass fibers. For example, many portions of the twist frame, loom and knitting device are formed from metallic materials such as steel, which has a Mohs' hardness up to about 8.5². Abrasive wear of glass fiber strands from contact with asperities of these solid objects causes strand breakage during processing and surface defects in products such as woven cloth and composites, which increases waste and manufacturing cost.
² Handbook of Chemistry and Physics at page F-22.

To minimize abrasive wear, the glass fibers of the glass fiber strands of the present invention are at least partially, and preferably fully, coated with inorganic solid lubricant particles 18 having a hardness value which does not exceed, i.e., is less than or equal to, a hardness value of the glass fiber(s). The hardness values of the inorganic solid lubricant particles and glass fibers can be determined by any conventional hardness measurement method, such as Vickers or Brinell hardness, but is preferably determined according to the original Mohs' hardness scale which indicates the relative scratch resistance of the surface of a material. The Mohs' hardness value of glass fibers generally ranges from about 4.5 to about 6.5, and is preferably about 6. (See R. Weast (Ed.), Handbook of Chemistry and Physics, CRC Press (1975) at page F-22, which is hereby incorporated by reference.) The Mohs' hardness value of the inorganic solid lubricant particles preferably ranges from about 0.5 to about 6. The Mohs' hardness values of several non-limiting examples of inorganic solid lubricants suitable for use in the present invention are given in Table A below.

**Table A**

| Solid Lubricant Material | Mohs' hardness (original scale) |
|---|---|
| boron nitride | about 2³ |
| graphite | about 0.5-1⁴ |
| molybdenum disulfide | about 1⁵ |
| aluminum | about 2.5⁶ |
| copper | about 2.5-3⁷ |
| gold | about 2.5-3⁸ |
| silver | about 2.5-4⁹ |
| talc | about 1-1.5¹⁰ |
| mica | about 2.8-3.2¹¹ |
| kaolinite | about 2.0-2.5¹² |
| gypsum | about 1.6-2¹³ |
| calcite (calcium carbonate) | about 3¹⁴ |
| calcium fluoride | about 4¹⁵ |
| zinc oxide | about 4.5¹⁶ |
| zinc sulfide | about 3.5-4¹⁷ |

| | |
|---|---|
| ³ K. Ludema, Friction, Wear, Lubrication, (1996) at page 27, which is hereby incorporated by reference. | |
| ⁴ Handbook of Chemistry and Physics at page F-22. | |
| ⁵ According to R. Lewis, Sr., Hawley's Condensed Chemical Dictionary, (12th Ed. 1993) at page 793, which is hereby incorporated by reference. | |
| ⁶ Friction, Wear, Lubrication at page 27. | |
| ⁷ Handbook of Chemistry and Physics at page F-22. | |
| ⁸ Handbook of Chemistry and Physics at page F-22. | |
| ⁹ Handbook of Chemistry and Physics at page F-22. | |
| ¹⁰ Hawley's Condensed Chemical Dictionary, (12th Ed. 1993) at page 1113, which is hereby incorporated by reference. | |
| ¹¹ Hawley's Condensed Chemical Dictionary, (12th Ed. 1993) at page 784, which is hereby incorporated by reference. | |
| ¹² Handbook of Chemistry and Physics at page F-22. | |
| ¹³ Handbook of Chemistry and Physics at page F-22. | |
| ¹⁴ Friction, Wear, Lubrication at page 27. | |
| ¹⁵ Friction, Wear, Lubrication at page 27. | |
| ¹⁶ Friction, Wear, Lubrication at page 27. | |
| ¹⁷ R. Weast (Ed.), Handbook of Chemistry and Physics. CRC Press (71^{st} Ed. 1990) at page 4-158. | |

As mentioned above, the Mohs' hardness scale relates to the resistance of a material to scratching. The instant invention therefore contemplates particles that have a hardness at their surface that is different from the hardness of the internal portions of the particle beneath its surface. More specifically, the surface of the particle can be modified in any manner well known in the art, including but not limited to coating, cladding or encapsulating the particle or chemically changing its surface characteristics using techniques known in the art, such that the surface hardness of the particle is not greater than the hardness of the glass fibers while the hardness of the particle beneath the surface is greater than the hardness of the glass fibers. For example but not limiting the present invention, inorganic particles such as silicon carbide and aluminum nitride can be provided with a silica, carbonate or nanoclay coating. In addition, silane coupling agents with alkyl side chains can be reacted with the surface of many oxide particles to provide a "softer" surface.

Inorganic solid lubricant particles useful in the present invention are selected from non-hydratable inorganic solid lubricant particles, hydratable (or hydrated) inorganic solid lubricant particles and mixtures thereof. As used herein, "non-hydratable" means that the solid inorganic lubricant particles do not react with molecules of water to form hydrates and do not contain water of hydration or water of crystallization. A "hydrate" is produced by the reaction of molecules of water with a substance in which the H-OH bond is not split. (See R. Lewis, Sr., Hawley's Condensed Chemical Dictionary, (12th Ed. 1993) at pages 609-610 and T. Perros, Chemistry, (1967) at pages 186-187, which are hereby incorporated by reference.) In the formulas of hydrates, the addition of the water molecules is conventionally indicated by a centered dot, e.g., 3MgO•4SiO₂•H₂O (talc), Al₂O₃•2SiO₂•2H₂O (kaolinite) . Structurally, hydratable inorganic materials include at least one hydroxyl group within a layer of a crystal lattice (but not including hydroxyl groups in the surface planes of a unit structure or materials which absorb water on their surface planes or by capillary action), for example as shown in the structure of kaolinite given in Fig. 3.8 at page 34 of J. Mitchell, Fundamentals of Soil Behavior (1976) and as shown in the structure of 1:1 and 2:1 layer minerals shown in Figs. 18 and 19, respectively, of H. van Olphen, Clay Colloid Chemistry, (2d Ed. 1977) at page 62, which are hereby incorporated by reference. A "layer" of a crystal lattice is a combination of sheets, which is a combination of planes of atoms. (See Minerals in Soil Environments, Soil Science Society of America (1977) at page 196-199, which is hereby incorporated by reference.) The assemblage of a layer and interlayer material (such as cations) is referred to as a unit structure.

Hydrates contain coordinated water, which coordinates the cations in the hydrated material and cannot be removed without the breakdown of the structure, and/or structural water, which occupies interstices in the structure to add to the electrostatic energy without upsetting the balance of charge. (See R. Evans, An Introduction to Crystal Chemistry, (1948) at page 276, which is hereby incorporated by reference.)

In a preferred embodiment, the inorganic solid lubricant particles have a lamellar structure. Particles having a lamellar or hexagonal crystal structure are composed of sheets or plates of atoms in hexagonal array, with strong bonding within the sheet and weak van der Waals bonding between sheets, providing low shear strength between sheets. (See Friction, Wear, Lubrication at page 125; Solid Lubricants and Self-Lubricating Solids at pages 19-22, 42-54, 75-77, 80-81, 82, 90-102, 113-120 and 128; and W. Campbell "Solid Lubricants", Boundary Lubrication; An Appraisal of World Literature, ASME Research Committee on Lubrication (1969) at pages 202- 203, which are hereby incorporated by reference.) Inorganic solid lubricant particles having a lamellar fullerene (buckyball) structure are also useful in the present invention.

Non-limiting examples of suitable non-hydratable inorganic solid lubricant particles having a lamellar structure include boron nitride, graphite, metal dichaicogenides, cadmium iodide, silver sulfide and mixtures thereof. Preferred non-hydratable inorganic solid lubricant particles include boron nitride, metal dichalcogenides, cadmium iodide, silver sulfide and mixtures thereof. Suitable metal dichalcogenides include molybdenum disulfide, molybdenum diselenide, tantalum disulfide, tantalum diselenide, tungsten disulfide, tungsten diselenide and mixtures thereof.

Boron nitride particles having a hexagonal crystal structure are most preferred for use in the aqueous sizing composition. Non-limiting examples of boron nitride particles suitable for use in the present invention are PolarTherm® 100 Series (PT 120, PT 140, PT 160 and PT 180), 300 Series (PT 350) and 600 Series (PT 620, PT 630, PT 640 and PT 670) boron nitride powder particles which are commercially available from Advanced Ceramics Corporation of Lakewood, Ohio. (See "PolarTherm® Thermally Conductive Fillers for Polymeric Materials", a technical bulletin of Advanced Ceramics Corporation of Lakewood, Ohio (1996), which is hereby incorporated by reference.) These particles have a thermal conductivity of about 250-300 Watts per meter K at 25°C, a dielectric constant of about 3.9 and a volume resistivity of about 10¹⁵ ohm-centimeters. The 100 Series powder has an average particle size ranging from about 5 to about 14 micrometers, the 300 Series has an average particle size ranging from about 100 to about 150 micrometers and the 600 series has an average particle size ranging from about 16 to greater than about 200 micrometers.

Referring to Fig. 1, the average particle size 19 (equivalent spherical diameter) of the inorganic solid particles 18 is generally less than about 1000 micrometers, preferably ranges from about 0.001 to about 100 micrometers, and more preferably about 0.1 to about 25 micrometers. The configuration or shape of the solid particles 18 can be generally spherical (such as beads or microbeads), cubic, platy or acicular (elongated or fibrous), as desired. For more information on suitable particle characteristics, see H. Katz et al. (Ed.), Handbook of Fillers and Plastics, (1987) at pages 9-10, which are hereby incorporated by reference.

The non-hydratable inorganic solid lubricant particles 18 can be present in a dispersion, suspension or emulsion in water. Other solvents, such as mineral oil or alcohol (preferably less than about 5 weight percent), can be included in the sizing composition, if desired. The amount of non-hydratable inorganic solid lubricant particles 18 in the aqueous sizing composition can range from about 0.001 to about 99 weight percent on a total weight basis, preferably about 1 to about 50 weight percent, and more preferably about 25 weight percent. A non-limiting example of a preferred dispersion of about 25 weight percent boron nitride particles in water is ORPAC BORON NITRIDE RELEASECOAT-CONC which is commercially available from ZYP Coatings, Inc. of Oak Ridge, Tennessee. (See "ORPAC BORON NITRIDE RELEASECOAT-CONC", a technical bulletin of ZYP Coatings, Inc., which is hereby incorporated by reference.) According to the supplier, the boron nitride particles in this product have an average particle size of less than about 3 micrometers. This dispersion has about 1 percent of magnesium-aluminum silicate, which according to the supplier binds the boron nitride particles to the substrate to which the dispersion is applied. Other useful products which are commercially available from ZYP Coatings include BORON NITRIDE LUBRICOAT® paint, BRAZE STOP and WELD RELEASE products.

In an alternative preferred embodiment, the sizing composition can comprise non-hydratable metallic inorganic solid lubricant particles selected from the group consisting of indium, thallium, tin, copper, zinc, gold, silver and mixtures thereof. Other suitable non-hydratable inorganic solid lubricant particles include calcium carbonate, calcium fluoride, zinc oxide and mixtures thereof.

In an alternative preferred embodiment, the inorganic solid lubricant particles are thermally conductive, i.e., have a thermal conductivity greater than about 30 Watts per meter K, such as for example boron nitride, graphite and the metallic inorganic solid lubricants discussed above. The thermal conductivity of a solid material can be determined by any method known to one skilled in the art, such as the guarded hot plate method according to ASTM C-177-85 (which is hereby incorporated by reference) at a temperature of about 300K.

In another alternative preferred embodiment, the non-hydratable inorganic solid lubricant particles are electrically insulative or have high electrical resistivity, i.e., have an electrical resistivity greater than about 1000 microohm-cm, such as for example boron nitride.

While not preferred, the aqueous sizing composition can contain hydratable or hydrated inorganic solid lubricant materials in addition to the non-hydratable inorganic solid lubricant materials discussed above. Non-limiting examples of such hydratable inorganic solid lubricant materials are clay mineral phyllosilicates, including micas (such as muscovite), talc, kaolin, kaolinite, montmorillonite and gypsum (CaSO₄•2H₂O).

While the sizing composition can contain up to about 50 weight percent of hydratable inorganic lubricant particles, silica particles or calcium carbonate on a total solids basis, preferably, the sizing composition is essentially free of hydratable inorganic solid lubricant particles or silica particles or calcium carbonate, i.e., comprises less than about 20 weight percent of hydratable inorganic lubricant particles, abrasive silica particles or calcium carbonate on a total solids basis, more preferably less than about 5 weight percent, and most preferably less than 0.001 weight percent.

The inorganic solid lubricant comprises about 0.001 to about 99 weight percent of the sizing composition on a total solids basis, preferably, about 1 to about 80 weight percent, and more preferably about 1 to about 40 weight percent. In a preferred embodiment, the sizing composition can contain about 0.001 to 5% boron nitride on total solids basis.

In addition to the non-hydratable inorganic solid lubricant, the aqueous sizing composition preferably comprises one or more polymeric materials, such as thermosetting materials, thermoplastic materials, starches and mixtures thereof. Preferably, the polymeric materials form a generally continuous film when applied to the surface 16 of the glass fibers. Generally, the amount of polymeric material can range from about 1 to about 99 weight percent of the aqueous sizing composition on a total solids basis, preferably about 20 to about 99 weight percent and more preferably about 60 to about 99 weight percent.

Thermosetting polymeric materials are preferred polymeric materials for use in the aqueous sizing composition for coating glass fiber strands of the present invention. Such materials are compatible with thermosetting matrix materials used as laminates for printed circuit boards, such as FR-4 epoxy resins, which are polyfunctional epoxy resins and in one particular embodiment of the invention is a difunctional brominated epoxy resins. (See 1 Electronic Materials Handbook™, ASM International (1989) at pages 534-537, which are hereby incorporated by reference,)

Useful thermosetting materials include thermosetting polyesters, epoxy materials, vinyl esters, phenolics, aminoplasts, thermosetting polyurethanes and mixtures thereof. Suitable thermosetting polyesters include STYPOL polyesters which are commercially available from Cook Composites and Polymers of Port Washington, Wisconsin and NEOXIL polyesters which are commercially available from DSM B.V. of Como, Italy.

In a preferred embodiment, the thermosetting polymeric material is an epoxy material. Useful epoxy materials contain at least one epoxy or oxirane group in the molecule, such as polyglycidyl ethers of polyhydric alcohols or thiols. Examples of suitable epoxy film-forming polymers include EPON® 826 and EPON® 880 epoxy resins, which are commercially available from Shell Chemical Company of Houston, Texas.

Useful thermoplastic polymeric materials include vinyl polymers, thermoplastic polyesters, polyolefins, polyamides (e.g. aliphatic polyamides or aromatic polyamides such as aramid), thermoplastic polyurethanes, acrylic polymers and mixtures thereof. Preferred vinyl polymers useful in the present invention include polyvinyl pyrrolidones such as PVP K-15, PVP K-30, PVP K-60 and PVP K-90, each of which are commercially available from ISP Chemicals of Wayne, New Jersey. Other suitable vinyl polymers include Resyn 2828 and Resyn 1037 vinyl acetate copolymer emulsions which are commercially available from National Starch, and other polyvinyl acetates such as are commercially available from H. B. Fuller and Air Products and Chemicals Co. of Allentown, Pennsylvania.

Thermoplastic polyesters useful in the present invention include DESMOPHEN 2000 and DESMOPHEN 2001 KS, both of which are commercially available from Bayer of Pittsburgh, Pennsylvania. A preferred polyester is RD-847A polyester resin which is commercially available from Borden Chemicals of Columbus, Ohio. Useful polyamides include the VERSAMID products which are commercially available from General Mills Chemicals, Inc. Useful thermoplastic polyurethanes include WITCOBOND® W-290H which is commercially available from Witco Chemical Corp. of Chicago, Illinois and RUCOTHANE® 2011L polyurethane latex which is commercially available from Ruco Polymer Corp. of Hicksville, New York.

The aqueous sizing composition can comprise a mixture of one or more thermosetting polymeric materials with one or more thermoplastic polymeric materials. In a preferred embodiment for laminates for printed circuit boards, the polymeric materials of the aqueous sizing composition comprise a mixture of RD-847A polyester resin, PVP K-30 polyvinyl pyrrolidone, DESMOPHEN 2000 polyester and VERSAMID polyamide. In an alternative preferred embodiment suitable for laminates for printed circuit boards, the polymeric materials of the aqueous sizing composition comprise a mixture of EPON 826 epoxy resin and PVP K-30 polyvinyl pyrrolidone.

Useful starches include those prepared from potatoes, corn, wheat, waxy maize, sago, rice, milo and mixtures thereof. A non-limiting example of a useful starch is Kollotex 1250 (a low viscosity, low amylose potato-based starch etherified with ethylene oxide) which is commercially available from AVEBE of the Netherlands.

The polymeric materials can be water soluble, emulsifiable, dispersible and/or curable. As used herein, "water soluble" means that the polymeric materials are capable of being essentially uniformly blended and/or molecularly or ionically dispersed in water to form a true solution. (See Hawley's at page 1075, which is hereby incorporated by reference.) "Emulsifiable" means that the polymeric materials are capable of forming an essentially stable mixture or being suspended in water in the presence of an emulsifying agent. (See Hawley's at page 461, which is hereby incorporated by reference.) Non-limiting examples of suitable emulsifying agents are set forth below. "Dispersible" means that any of the components of the polymeric materials are capable of being distributed throughout water as finely divided particles, such as a latex. (See Hawley's at page 435, which is hereby incorporated by reference.) The uniformity of the dispersion can be increased by the addition of wetting, dispersing or emulsifying agents (surfactants), which are discussed below. "Curable" means that the polymeric materials and other components of the sizing composition are capable of being coalesced into a film or crosslinked to each other to change the physical properties of the polymeric materials (See Hawley's at page 331, which is hereby incorporated by reference.)

In addition to or in lieu of the polymeric materials discussed above, the aqueous sizing composition preferably comprises one or more coupling agents such as organo silane coupling agents, transition metal coupling agents, phosphonate coupling agents, aluminum coupling agents, amino-containing Werner coupling agents and mixtures thereof. These coupling agents typically have dual functionality. Each metal or silicon atom has attached to it one or more groups which can react or compatibilize with the fiber surface and/or the components of the aqueous sizing composition. As used herein, the term "compatibilize" means that the groups are chemically attracted, but not bonded, to the fiber surface and/or the components of the sizing composition, for example by polar, wetting or solvation forces. Examples of hydrolyzable groups include:

-OR¹,

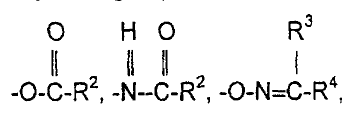

-O-N=C―R⁵,

and the monohydroxy and/or cyclic C₂-C₃ residue of a 1,2- or 1,3 glycol, wherein R¹ is C₁-C₃ alkyl; R² is H or C₁-C₄ alkyl; R³ and R⁴ are independently selected from H, C₁-C₄ alkyl or C₆-C₈ aryl; and R⁵ is C₄-C₇ alkylene. Examples of suitable compatibilizing or functional groups include epoxy, glycidoxy, mercapto, cyano, allyl, alkyl, urethano, halo, isocyanato, ureido, imidazolinyl, vinyl, acrylato, methacrylato, amino or polyamino groups.

Functional organo silane coupling agents are preferred for use in the present invention. Examples of useful functional organo silane coupling agents include gamma-aminopropyltrialkoxysilanes, gamma-isocyanatopropyltriethoxysilane, vinyl-trialkoxysilanes, glycidoxypropyltrialkoxysilanes and ureidopropyltrialkoxysilanes. Preferred functional organo silane coupling agents include A-187 gamma-glycidoxypropyltrimethoxysilane, A-174 gamma-methacryloxypropyltrimethoxysilane, A-1100 gamma-aminopropyltriethoxysilane silane coupling agents, A-1108 amino silane coupling agent and A-1160 gamma-ureidopropyltriethoxysilane (each of which are commercially available from OSi Specialties, Inc. of Tarrytown, New York). The organo silane coupling agent can be at least partially hydrolyzed with water prior to application to the fibers, preferably at about a 1:1 stoichiometric ratio or, if desired, applied in unhydrolyzed form.

Suitable transition metal coupling agents include titanium, zirconium, yttrium and chromium coupling agents. Suitable titanate coupling agents and zirconate coupling agents are commercially available from Kenrich Petrochemical Company. Suitable chromium complexes are commercially available from E.I. duPont de Nemours of Wilmington, Delaware. The amino-containing Werner-type coupling agents are complex compounds in which a trivalent nuclear atom such as chromium is coordinated with an organic acid having amino functionality. Other metal chelate and coordinate type coupling agents known to those skilled in the art can be used herein.

The amount of coupling agent can range from about 1 to about 99 weight percent of the aqueous sizing composition on a total solids basis, and preferably about 1 to about 10 weight percent.

The aqueous sizing composition can further comprise one or more organic lubricants which are chemically different from the polymeric materials discussed above. While the aqueous sizing composition can comprise up to about 60 weight percent organic lubricants, preferably the sizing composition is essentially free of organic lubricants, i.e., contains less than about 20 weight percent of organic lubricants, and more preferably is free of organic lubricants. Such organic lubricants include cationic, non-ionic or anionic lubricants and mixtures thereof, such as amine salts of fatty acids, alkyl imidazoline derivatives such as CATION X, which is commercially available from Rhone Poulenc of Princeton, New Jersey, acid solubilized fatty acid amides, condensates of a fatty acid and polyethylene imine and amide substituted polyethylene imines, such as EMERY® 6717, a partially amidated polyethylene imine commercially available from Henkel Corporation of Kankakee, Illinois.

The aqueous sizing composition can include one or more emulsifying agents for emulsifying or dispersing components of the aqueous sizing composition, such as the inorganic particles. Non-limiting examples of suitable emulsifying agents or surfactants include polyoxyalkylene block copolymers (such as PLURONIC™ F-108 polyoxypropylene-polyoxyethylene copolymer which is commercially available from BASF Corporation of Parsippany, New Jersey), ethoxylated alkyl phenols (such as IGEPAL CA-630 ethoxylated octylphenoxyethanol which is commercially available from GAF Corporation of Wayne, New Jersey), polyoxyethylene octylphenyl glycol ethers, ethylene oxide derivatives of sorbitol esters, polyoxyethylated vegetable oils (such as ALKAMULS EL-719, which is commercially available from Rhone-Poulenc) and nonylphenol surfactants (such as MACOL NP-6 which is commercially available from BASF of Parsippany, New Jersey). Generally, the amount of emulsifying agent can range from about 1 to about 30 weight percent of the aqueous sizing composition on a total solids basis.

The aqueous sizing composition can include one or more aqueous soluble, emulsifiable or dispersible wax materials such as vegetable, animal, mineral, synthetic or petroleum waxes. Preferred waxes are petroleum waxes such as MICHEM® LUBE 296 microcrystalline wax, POLYMEKON® SPP-W microcrystalline wax and PETROLITE 75 microcrystalline wax which are commercially available from Michelman Inc. of Cincinnati, Ohio and the Petrolite Corporation of Tulsa, Oklahoma, respectively. Generally, the amount of wax can be about 1 to about 10 weight percent of the sizing composition on a total solids basis.

Crosslinking materials, such as melamine formaldehyde, and plasticizers, such as phthalates, trimellitates and adipates, can also be included in the aqueous sizing composition. The amount of crosslinker or plasticizer can range from about 1 to about 5 weight percent of the sizing composition on a total solids basis.

Other additives can be included in the aqueous sizing composition, such as silicones, fungicides, bactericides and anti-foaming materials, generally in an amount of less than about 5 weight percent. Organic and/or inorganic acids or bases in an amount sufficient to provide the aqueous sizing composition with a pH of about 2 to about 10 can also be included in the sizing composition. A non-limiting example of a suitable silicone emulsion is LE-9300 epoxidized silicone emulsion which is commercially available from OSi Specialties, Inc. of Danbury, Connecticut. An example of a suitable bactericide is Biomet 66 antimicrobial compound, which is commercially available from M & T Chemicals of Rahway, New Jersey. Suitable anti-foaming materials are the SAG materials which are commercially available from OSi Specialties, Inc. of Danbury, Connecticut and MAZU DF-136 which is available from BASF Company of Parsippany, New Jersey. Ammonium hydroxide can be added to the sizing composition for sizing stabilization, if desired. Water (preferably deionized) is included in the aqueous sizing composition in an amount sufficient to facilitate application of a generally uniform coating upon the strand. The weight percentage of solids of the aqueous sizing composition generally ranges from about 1 to about 20 weight percent.

The aqueous sizing composition is preferably essentially free of glass materials. As used herein, "essentially free of glass materials" means that the sizing composition comprises less than 20 volume percent of glass matrix materials for forming glass composites, preferably less than about 5 volume percent, and more preferably is free of glass materials. Examples of such glass matrix materials include black glass ceramic matrix materials or aluminosilicate matrix materials such as are well known to those skilled in the art.

In a preferred embodiment for weaving fabric for printed circuit boards, the glass fibers of the coated fiber strands of the present invention have applied thereto a primary layer of a dried residue of an aqueous sizing composition comprising PolarTherm® 160 boron nitride powder and/or BORON NITRIDE RELEASECOAT dispersion, EPON 826 epoxy film-forming material, PVP K-30 polyvinyl pyrrolidone, A-187 epoxy-functional organo silane coupling agent, ALKAMULS EL-719 polyoxyethylated vegetable oil, IGEPAL CA-630 ethoxylated octylphenoxyethanol, KESSCO PEG 600 polyethylene glycol monolaurate ester which is commercially available from Stepan Company of Chicago, Illinois and EMERY® 6717 partially amidated polyethylene imine.

In a more preferred embodiment for weaving cloth, glass fibers of the coated fiber strands of the present invention have applied thereto a primary layer of a dried residue of an aqueous sizing composition comprising PolarTherm® 160 boron nitride powder and/or BORON NITRIDE RELEASECOAT dispersion, RD-847A polyester, PVP K-30 polyvinyl pyrrolidone, DESMOPHEN 2000 polyester, A-174 acrylic-functional organo silane coupling agents and A-187 epoxy-functional organo silane coupling agents, PLURONIC F-108 polyoxypropylene-polyoxyethylene copolymer, MACOL NP-6 nonylphenol surfactant, VERSAMID 140 and LE-9300 epoxidized silicone emulsion.

The aqueous sizing compositions of the present invention can be prepared by any suitable method such as conventional mixing well known to those skilled in the art. Preferably the components discussed above are diluted with water to have the desired weight percent solids and mixed together. Powdered non-hydratable inorganic lubricants can be premixed with water or added to the polymeric material prior to mixing with the other components of the sizing.

In preferred methods of the present invention, the primary layer of sizing can be applied to the glass fiber surfaces in many ways, for example by contacting the fibers with a roller or belt applicator, spraying or other means. The sized fibers are at least partially dried at room temperature or at elevated temperatures. The dryer removes excess moisture from the fibers and, if present, cures any curable sizing composition components. The temperature and time for drying the glass fibers will depend upon such variables as the percentage of solids in the sizing composition, components of the sizing composition and type of glass fiber. The sizing composition is typically present on the fibers in an amount between about 0.1 percent and about 5 percent by weight after drying.

The fibers are gathered into strands having 1 to about 15,000 fibers per strand, and preferably about 100 to about 1600 fibers per strand. The average filament diameter of the fibers can range from about 3 to about 30 micrometers.

A secondary layer of a secondary coating composition can be applied over the primary layer in an amount effective to coat or impregnate the portion of the strands, for example by dipping the strand in a bath containing the composition, spraying the composition upon the strand or by contacting the strand with an applicator as discussed above. The coated strand can be passed through a die to remove excess coating composition from the strand and/or dried as discussed above for a time sufficient to at least partially dry or cure the secondary coating composition. The method and apparatus for applying the secondary coating composition to the strand is determined in part by the configuration of the strand material. The strand is preferably dried after application of the secondary coating composition in a manner well known in the art.

Suitable secondary coating compositions can include one or more film-forming materials, lubricants and other additives such as are discussed above. The secondary coating is different from the sizing composition, i.e., it
(1) contains at least one component which is chemically different from the components of the sizing composition; or (2) contains at least one component in an amount which is different from the amount of the same component contained in the sizing composition. Non-limiting examples of suitable secondary coating compositions including polyurethane are disclosed in U.S. Patent Nos. 4,762,750 and 4,762,751, which are hereby incorporated by reference.

Referring now to Fig. 2, in an alternative preferred embodiment according to the present invention, the glass fibers 212 of the coated fiber strand 210 can having applied thereto a primary layer 214 of a dried residue of a sizing composition which can include any of the sizing components in the amounts discussed above. Examples of suitable sizing compositions are set forth in Loewenstein at pages 237-291 (3d Ed. 1993) and U.S. Patent Nos. 4,390,647 and 4,795,678, each of which is hereby incorporated by reference. A secondary or principal layer 215 of an aqueous secondary coating composition is applied to at least a portion, and preferably over the entire outer surface, of the primary layer 214. The aqueous secondary coating composition comprises one or more types of hydratable and/or non-hydratable inorganic lubricant particles 216 such as are discussed in detail above. Preferably, the inorganic lubricant particles in the secondary coating composition are non-hydratable, lamellar inorganic lubricant particles such as are discussed above. The amount of inorganic lubricant particles in the secondary coating composition can range from about 1 to about 99 weight percent on a total solids basis and preferably about 20 to about 90 weight percent. The percentage of solids of the aqueous secondary coating composition generally ranges from about 5 to about 50 weight percent.

In an alternative embodiment shown in Fig. 3, a tertiary layer 320 of a tertiary coating composition can be applied to at least a portion of the surface, and preferably over the entire surface, of a secondary layer 315 of coated fiber strand 310, i.e., such a fiber strand 312 would have a primary layer 314 of sizing, a secondary layer 315 of a secondary coating composition and a tertiary, outer layer 320 of the tertiary coating. The tertiary coating is different from the sizing composition and the secondary coating composition, i.e., the tertiary coating composition (1) contains at least one component which is chemically different from the components of the sizing and secondary coating composition; or (2) contains at least one component in an amount which is different from the amount of the same component contained in the sizing or secondary coating composition.

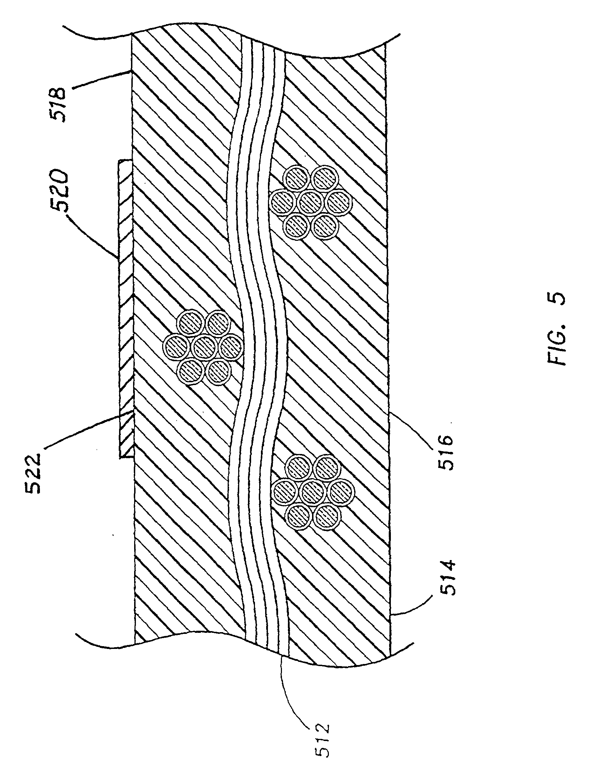

In this embodiment, the secondary coating composition comprises one or more polymeric materials discussed above, such as polyurethane, and the tertiary powdered coating composition comprises powdered, non-hydratable, lamellar inorganic lubricant particles, such as the PolarTherm® boron nitride particles which are discussed above. Preferably, the powdered coating is applied by passing the strand having a liquid secondary coating composition applied thereto through a fluidized bed or spray device to adhere the powder particles to the tacky secondary coating composition. Alternatively, the strands can be assembled into a fabric 512 before a layer of tertiary coating is applied as shown in Figure 5. The weight percent of powdered, non-hydratable, lamellar inorganic lubricant particles adhered to the coated fiber strand 310 can range from about 0.1 to about 30 weight percent of the total weight of the dried strand.

The tertiary powdered coating can also include one or more polymeric materials such as are discussed above, such as acrylic polymers, epoxies, or polyolefins, conventional stabilizers and other modifiers known in the art of such coatings, preferably in dry powder form.

The coated fiber strands 10, 210, 310 discussed above can be used as continuous strand or further processed into diverse products such as chopped strand, twisted strand, roving and/or fabric, such as wovens, non-wovens, knits and mats.

The coated fiber strands 10, 210, 310 and products formed therefrom can be used in a wide variety of applications, but are preferably used as reinforcements for reinforcing polymeric matrix materials to form a composite, such as is shown in Fig. 5, which will be discussed in detail below. Such applications include but are not limited to laminates for printed circuit boards, reinforcements for telecommunications cables, and various other composites.

In a preferred method shown in Fig. 4, the strands 410 of the present invention can be used in a fabric forming operation as warp strands 414 and/or weft strands 416 to assemble a fabric 412 reinforcement by interweaving the weft fiber strand with the warp fiber strand.

The warp strands 414 can be twisted prior to secondary coating by any conventional twisting technique known to those skilled in the art, for example by using twist frames to impart twist to the strand at about 0.5 to about 3 turns per inch. The reinforcing fabric 412 can include about 5 to about 50 warp strands and preferably has about 3 to about 25 picks per centimeter (about 1 to about 15 picks per inch) of the weft strand. Referring to Fig. 4, suitable reinforcing fabric 412 can be formed by using any conventional fabric forming apparatus, such as a loom 420 or knitting machine. Examples of suitable looms include shuttle looms, air jet looms or rapier looms. A preferred loom is a Tsudakoma loom which is commercially available from Tsudakoma of Japan. The weave construction can be a regular plain weave or mesh (shown in Fig. 4), although any other weaving style well known to those skilled in the art, such as a twill weave or satin weave, can be used.

In the twisting, weaving and knitting operations, the first fiber strand 410 (warp or weft) is subjected to abrasive wear by sliding contact with surface asperities 418 of solid objects, such as portions of the twist frame, weaving and knitting devices. For example, as shown in Fig. 4, the strand 410 slidingly contacts portions of the loom 420, such as the heddles 422 and reed 424. The strands of the present invention have a coating of inorganic lubricant particles which inhibit such abrasive wear, thereby decreasing the possibility of broken strands.

Referring now to Fig. 5, the fabric 512 can be used to form a composite or laminate 514 by coating and/or impregnating with a polymeric film-forming thermoplastic or thermosetting matrix material 516. The composite or laminate 514 is suitable for use an electronic support. As used herein, "electronic support" means a structure that mechanically supports and/or electrically interconnects elements including but not limited to active electronic components, passive electronic components, printed circuits, integrated circuits, semiconductor devices and other hardware associated with such elements including but not limited to connectors, sockets, retaining clips and heat sinks.

Matrix materials useful in the present invention include thermosetting materials such as thermosetting polyesters, vinyl esters, epoxides (containing at least one epoxy or oxirane group in the molecule, such as polyglycidyl ethers of polyhydric alcohols or thiols), phenolics, aminoplasts, thermosetting polyurethanes, derivatives and mixtures thereof. Preferred matrix materials for forming laminates for printed circuit boards are FR-4 epoxy resins, polyimides and liquid crystalline polymers, the compositions of which are well know to those skilled in the art. If further information regarding such compositions is needed, see 1 Electronic Materials Handbook™, ASM International (1989) at pages 534-537.

Non-limiting examples of suitable polymeric thermoplastic matrix materials include polyolefins, polyamides, thermoplastic polyurethanes and thermoplastic polyesters, vinyl polymers and mixtures thereof. Further examples of useful thermoplastic materials include polyimides, polyether sulfones, polyphenyl sulfones, polyetherketones, polyphenylene oxides, polyphenylene sulfides, polyacetals, polyvinyl chlorides and polycarbonates.

Other components which can be included with the polymeric matrix material and reinforcing material in the composite include colorants or pigments, lubricants or processing aids, ultraviolet light (UV) stabilizers, antioxidants, other fillers and extenders.

The fabric 512 can be coated and impregnated by dipping the fabric 512 in a bath of the polymeric matrix material 516, for example, as discussed in R. Tummala (Ed.), Microelectronics Packaging Handbook, (1989) at pages 895-896, which are hereby incorporated by reference. More generally, chopped or continuous fiber strand reinforcing material can be dispersed in the matrix material by hand or any suitable automated feed or mixing device which distributes the reinforcing material generally evenly throughout the polymeric matrix material. For example, the reinforcing material can be dispersed in the polymeric matrix material by dry blending all of the components concurrently or sequentially.

The polymeric matrix material 516 and strand can be formed into a composite or laminate 514 by a variety of methods which are dependent upon such factors as the type of polymeric matrix material used. For example, for a thermosetting matrix material, the composite can be formed by compression or injection molding, pultrusion, filament winding, hand lay-up, spray-up or by sheet molding or bulk molding followed by compression or injection molding. Thermosetting polymeric matrix materials can be cured by the inclusion of crosslinkers in the matrix material and/or by the application of heat, for example. Suitable crosslinkers useful to crosslink the polymeric matrix material are discussed above. The temperature and curing time for the thermosetting polymeric matrix material depends upon such factors as the type of polymeric matrix material used, other additives in the matrix system and thickness of the composite, to name a few.

For a thermoplastic matrix material, suitable methods for forming the composite include direct molding or extrusion compounding followed by injection molding. Methods and apparatus for forming the composite by the above methods are discussed in I. Rubin, Handbook of Plastic Materials and Technology (1990) at pages 955-1062, 1179-1215 and 1225-1271, which are hereby incorporated by reference.

In a particular embodiment of the invention shown in Fig. 5, the composite or laminate 514 includes fabric 512 impregnated with a compatible matrix material 516. The impregnated fabric can then be squeezed between a set of metering rolls to leave a measured amount of matrix material, and dried to form an electronic support in the form of a semi-cured substrate or prepreg. An electrically conductive layer 520 can be positioned along a portion of a side 522 of the prepreg in a manner to be discussed below in the specification, and the prepreg is cured to form an electronic support 518 with an electrically conductive layer. In another embodiment of the invention, and more typically in the electronic support industry, two or more prepregs are combined with an electrically conductive layer and laminated together and cured in a manner well known to those skilled in the art, to form a multilayered electronic support. For example, but not limiting the present invention, the prepreg stack can be laminated by pressing the stack, eg. between polished steel plates, at elevated temperatures and pressures for a predetermined length of time to cure the polymeric matrix and form a laminate of a desired thickness. A portion of one or more of the prepregs can be provided with an electrically conductive layer either prior to or after lamination and curing such that the resulting electronic support is a laminate having at least one electrically conductive layer along a portion of an exposed surface (hereinafter referred to as a "clad laminate").

Circuits can then be formed from the electrically conductive layer(s) of the single layer or multilayered electronic support using techniques well known in the art to construct an electronic support in the form of a printed circuit board or printed wiring board (hereinafter collectively referred to as "electronic circuit boards"). If desired, apertures or holes (also referred to as "vias") can be formed in the electronic supports, to allow for electrical interconnection between circuits and/or components on opposing surfaces of the electronic support, by any convenient manner known in the art, including but not limited to mechanical drilling and laser drilling. More specifically, after formation of the apertures, a layer of electrically conductive material is deposited on the walls of the aperture or the aperture is filled with an electrically conductive material to facilitate the required electrical interconnection and/or heat dissipation.

The electrically conductive layer 520 can be formed by any method well known to those skilled in the art. For example but not limiting the present invention, the electrically conductive layer can be formed by laminating a thin sheet or foil of metallic material onto at least a portion of a side of the semi-cured or cured prepreg or laminate. As an alternative, the electrically conductive layer can be formed by depositing a layer of metallic material onto at least a portion of a side of the semi-cured or cured prepreg or laminate using well known techniques including but not limited to electrolytic plating, electroless plating or sputtering. Metallic materials suitable for use as an electrically conductive layer include but are not limited to copper (which is preferred), silver, aluminum, gold, tin, tin-lead alloys, palladium and combinations thereof.

In another embodiment of the present invention, the electronic support can be in the form of a multilayered electronic circuit board constructed by laminating together one or more electronic circuit boards (described above) with one or more clad laminates (described above) and/or one or more prepregs (described above). If desired, additional electrically conductive layers can be incorporated into the electronic support, for example along a portion of an exposed side of the multilayered electronic circuit board. Furthermore, if required, additional circuits can be formed from the electrically conductive layers in a manner discussed above. It should be appreciated that depending on the relative positions of the layers of the multilayered electronic circuit board, the board can have both internal and external circuits. Additional apertures are formed, as discussed earlier, partially through or completely through the board to allow electrical interconnection between the layers at selected locations. It should be appreciated that the resulting structure can have some apertures that extend completely through the structure, some apertures that extend only partially through the structure, and some apertures that are completely within the structure.

The instant invention further contemplates the fabrication of multilayered laminates and electronic circuit boards which include at least one composite layer made according to the teachings herein and at least one composite layer made in a manner different from the composite layer taught herein, e.g. made using conventional glass fiber composite technology. More specifically and as is well known to those skilled in the art, traditionally the filaments in continuous glass fiber strands used in weaving fabric are treated with a starch/oil sizing which includes partially or fully dextrinized starch or amylose, hydrogenated vegetable oil, a cationic wetting agent, emulsifying agent and water, including but not limited to those disclosed in Lowenstein at pages 237-244 (3d Ed. 1993), which is hereby incorporated by reference. Warp yarns produced from these strands are thereafter treated with a solution prior to weaving to protect the strands against abrasion during the weaving process, e.g. poly(vinyl alcohol) as disclosed in U.S. Patent Nos.4,530,876 at column 3, line 67 through column 4, line 11, which is hereby incorporated by reference. This operation is commonly referred to as slashing. The poly(vinyl alcohol) as well as the starch/oil size are generally not compatible with the polymeric matrix material used by composite manufacturers and the fabric must be cleaned to remove essentially all organic material from the surface of the glass fibers prior to impregnating the woven fabric. This can be accomplished in a variety ways, for example by scrubbing the fabric or, more commonly, by heat treating the fabric in a manner well known in the art. As a result of the cleaning operation, there is no suitable interface between the polymeric matrix material used to impregnate the fabric and the cleaned glass fiber surface, so that a coupling agent must be applied to the glass fiber surface. This operation is sometime referred to by those skilled in the art as finishing. The coupling agents most commonly used in finishing operations are silanes, including but not limited to those disclosed in E. P. Plueddemann, Silane Coupling Agents (1982) at pages 146-147, which is hereby incorporated by reference. Also see Lowenstein at pages 249-256 (3d Ed. 1993). After treatment with the silane, the fabric is impregnated with a compatible polymeric matrix material, squeezed between a set of metering rolls and dried to form a semi-cured prepreg as discussed above. It should be appreciated that depending on the nature of the sizing, the cleaning operation and/or the matrix resin used in the composite, the slashing and/or finishing steps can be eliminated. One or more prepregs incorporating conventional glass fiber composite technology can then be combined with one or more prepregs incorporating the instant invention to form an electronic support as discussed above, and in particular a multilayered laminate or electronic circuit board. For more information regarding fabrication of electronic circuit boards, see 1 Electronic Materials Handbook™, ASM International (1989) at pages 113-115; R. Tummala (Ed.), Microelectronics Packaging Handbook, (1989) at pages 858-861 and 895-909; M. W. Jawitz, Printed Circuit Board Handbook (1997) at pages 9.1-9.42; and C. F. Coombs, Jr. (Ed.), Printed Circuits Handbook, (3d Ed. 1988), pages 6.1-6.7, which are hereby incorporated by reference.

The composites and laminates forming the electronic supports of the instant invention can be used to form packaging used in the electronics industry, and more particularly first, second and/or third level packaging, such as that disclosed in Tummala at pages 25-43, which is hereby incorporated by reference. In addition, the present invention can also be used for other packaging levels.

The present invention will now be illustrated by the following specific, non-limiting examples.

### EXAMPLE 1

The components in the amounts set forth in Table 1 were mixed to form aqueous forming size compositions A-D according to the present invention in a similar manner to that discussed above. Less than 1 weight percent of acetic acid was included in each composition.

Aqueous forming size compositions A-D and Comparative Sample No. 1 were coated onto E-glass fiber strands. Each of the forming size compositions had about 2.5 weight percent solids. Each coated glass fiber strand was twisted to form a yarn and wound onto bobbins in a similar manner using conventional twisting equipment.

**Table 1**

| | WEIGHT PERCENT OF COMPONENT ON TOTAL SOLIDS BASIS | | | | |
|---|---|---|---|---|---|
| | SAMPLE NO. | | | | |
| COMPONENT | A | B | C | D | Comp. Sample No.1 |
| Thermoplastic polyester film-forming polymer¹⁸ | 28.6 | 29.1 | 31.58 | 50.71 | 28.9 |
| Thermoplastic polyester film-forming polymer ¹⁹ | 43.7 | 39.1 | 0 | 0 | 44.1 |
| Epoxy film-forming polymer ²⁰ | 0 | 0 | 21.05 | 0 | 0 |
| Polyvinyl pyrrolidone²¹ | 0 | 9.7 | 15.79 | 15.21 | 0 |
| epoxy-functional organo silane coupling agent²² | 2.3 | 2.3 | 8.42 | 8.11 | 2.3 |
| acrylic-functional organo silane coupling agent²³ | 4.7 | 4.8 | 0 | 0 | 4.8 |
| amino-functional organo silane coupling agent²⁴ | 0 | 0 | 8.42 | 8.11 | 0 |
| polyoxyalkylene block copolymer²⁵ | 10.7 | 5.6 | 0 | 0 | 10.9 |
| Ethoxylated octylphenoxyethanol²⁶ | 0 | 0 | 4.74 | 6.39 | 0 |
| polyamide²⁷ | 4.8 | 4.8 | 0 | 0 | 4.8 |
| surfactant²⁸ | 3.6 | 3.6 | 4.74 | 6.39 | 3.6 |
| Organic lubricant²⁹ | 0 | 0 | 4.21 | 4.06 | 0 |
| polyoxyethylene polymer³⁰ | 0.6 | 0 | 0 | 0 | 0.6 |
| boron nitride powder particles³¹ | 1.0 | 1.0 | 0 | 0 | 0 |
| boron nitride particles in aqueous suspension³² | 0 | 0 | 1.05 | 1.01 | 0 |

| | | | | | |
|---|---|---|---|---|---|
| ¹⁸ RD-847A polyester resin which is commercially available from Borden Chemicals of Columbus, Ohio. | | | | | |
| ¹⁹ DESMOPHEN 2000 polyethylene adipate diol which is commercially available from Bayer of Pittsburgh, Pennsylvania. | | | | | |
| ²⁰ EPI-REZ® 3522-W-66 which is commercially available from Shell Chemical Co. of Houston, Texas. | | | | | |
| ²¹ PVP K-30 polyvinyl pyrrolidone which is commercially available from ISP Chemicals of Wayne, New Jersey. | | | | | |
| ²² A-187 gamma-glycidoxypropyltrimethoxysilane which is commercially available from OSi Specialties, Inc. of Tarrytown, New York. | | | | | |
| ²³ A-174 gamma-methacryloxypropyltrimethoxysilane which is commercially available from OSi Specialties, Inc. of Tarrytown, New York. | | | | | |
| ²⁴ A-1100 amino-functional organo silane coupling agent which is commercially available from OSi Specialties, Inc. of Tarrytown, New York. | | | | | |
| ²⁵ PLURONIC™ F-108 polyoxypropylene-polyoxyethylene copolymer which is commercially available from BASF Corporation of Parsippany, New Jersey. | | | | | |
| ²⁶ IGEPAL CA-630 ethoxylated octylphenoxyethanol which is commercially available from GAF Corporation of Wayne, New Jersey. | | | | | |
| ²⁷ VERSAMID 140 polyamide which is commercially available from General Mills Chemicals, Inc. | | | | | |
| ²⁸ MACOL NP-6 nonylphenol surfactant which is commercially available from BASF of Parsippany, New Jersey. | | | | | |
| ²⁹ EMERY® 6760 lubricant which is commercially available from Henkel Corporation of Kankakee, Illinois. | | | | | |
| ³⁰ POLYOX WSR-301 polyoxyethylene polymer which is commercially available from Union Carbide of Danbury, Connecticut. | | | | | |
| ³¹ PolarTherm® PT 160 boron nitride powder particles which are commercially available from Advanced Ceramics Corporation of Lakewood, Ohio. | | | | | |
| ³² ORPAC BORON NITRIDE RELEASECOAT-CONC boron nitride particles in aqueous dispersion which is commercially available from ZYP Coatings, Inc. of Oak Ridge, Tennessee. | | | | | |

The yarns of Samples A-D, Comparative Sample No. 1 and a Comparative Sample No. 2³³ were evaluated for several physical properties, such as loss on ignition (LOI), air jet compatibility (Air Drag), Friction Force and broken filaments.
³³ PPG Industries, Inc.'s 1383 commercially available fiber glass yarn product.

The average loss on ignition (weight percent of solids of the forming size composition divided by the total weight of the glass and dried forming size composition) of three trials of each Sample is set forth in Table 2.

Each yarn was evaluated for Air Drag Force or tension by feeding the yarn at a controlled feed rate of 274 meters (300 yards) per minute through a checkline tension meter, which applied a tension to the yarn, and a Ruti two millimeter diameter air nozzle at an air pressure of 310 kPa (45 pounds per square inch).

The Samples and Comparative Samples were also evaluated for Friction Force by applying a tension of about 30 grams to each yarn sample as the sample is pulled at a rate of 274 meters (300 yards) per minute through a pair of conventional tension measurement devices having a stationary chrome post of about 5 centimeters (2 inches) diameter mounted therebetween to displace the yarn about 5 centimeters from a straight line path between the tension measurement devices. The difference in force in grams is set forth in Table 2 below. The Friction Force test is intended to simulate the frictional forces to which the yarn is subjected during weaving operations.

Each sample and comparative sample was also evaluated for broken filaments using an abrasion tester. Two hundred grams of tension were applied to each test sample as each test sample was pulled at a rate of 0.46 meters (18 inches) per minute for five minutes through an abrasion testing apparatus. Two test runs of each sample and comparative sample were evaluated and the average of the number of broken filaments is reported in Table 4 below. The abrasion tester consisted of two parallel rows of steel reeds, each row being positioned about 1 inch apart. Each test yarn sample was threaded between two adjacent reeds of the first row of reeds, then threaded between two adjacent reeds of the second row of reeds, but displaced a distance of one-half inch between the rows of reeds. The reeds were displaced back and forth over a four inch length in a direction parallel to the direction of yarn travel at a rate of 240 cycles per minute. The results of Air Drag Force, Friction Force and Broken Filaments Under Abrasion for Samples A-D and the comparative samples are set forth in Table 2 below.

**Table 2**

| | Sample | | | | | |
|---|---|---|---|---|---|---|
| | A | B | C | D | Comparative Sample No. 1 | Comparative Sample No. 2 |
| LOI (weight percent) | 0.35 | 0.30 | 0.52 | 0.40 | 0.33 | 0.75 |
| Air Drag (grams) | 68.5 | 84.9 | 37.3 | 47.1 | 36.4 | 19.0 |
| Friction force (grams) | 24.7 | 18.3 | - | - | 23.9 | 38.1 |
| Number of broken filaments per yard of yarn | 2.0 | 1.0 | - | - | 3.8 | 1.0 |

As shown in Table 2, Samples A and B, which are coated with sizing compositions containing boron nitride according to the present invention, had few broken filaments, low frictional force and higher air drag values when compared to the Comparative Samples. Samples C and D also had higher air drag values than the Comparative Samples. The air drag test is a relative test intended to simulate the weft insertion process of an air jet loom in which the yarn is conveyed across the loom by air jet propulsion. Yarns which are more readily filamentized by the air jet provide greater surface area for air jet propulsion, which can facilitate yarn travel across the loom and increase productivity. The air drag values for Samples A-D (samples prepared according to the present invention) are higher than those of the Comparative Samples, which indicates superior air jet compatibility.

### EXAMPLE 2

Each of the components in the amounts set forth in Table 3 were mixed to form aqueous forming size compositions E, F, G and H according to the present invention and the Comparative Sample in a similar manner to that discussed above. Less than about 1 weight percent of acetic acid on a total weight basis was included in each composition.

Each of the aqueous forming size compositions of Table 3 were coated onto G-75 E-glass fiber strands. Each of the forming size compositions had between about 6 and about 25 weight percent solids.

**Table 3**

| | WEIGHT PERCENT OF COMPONENT ON TOTAL SOLIDS BASIS | | | | |
|---|---|---|---|---|---|
| | Sample No. | | | | |
| COMPONENT | E | F | G | H | Comp. Sample |
| Epoxy film-forming polymer³⁴ | 16.12 | 63.54 | 16.12 | 63.54 | 60.98 |
| Polyvinyl pyrrolidone³⁵ | 1.31 | 5.18 | 1.31 | 5.18 | 4.97 |
| Polyoxyethylated vegetable oil³⁶ | 1.63 | 6.44 | 1.63 | 6.44 | 6.18 |
| Ethoxylated octylphenoxyethanol³⁷ | 1.63 | 6.44 | 1.63 | 6.44 | 6.18 |
| polyethylene glycol monolaurate ester³⁸ | 0.79 | 3.11 | 0.79 | 3.11 | 2.98 |
| Epoxy-functional organo silane coupling agent³⁹ | 3.17 | 12.51 | 3.17 | 12.51 | 12.00 |
| Organic lubricant⁴⁰ | 0.40 | 1.56 | 0.40 | 1.56 | 1.50 |
| polyethylene emulsion⁴¹ | 0 | 0 | 0 | 0 | 4.61 |
| Boron nitride powder particles⁴² | 74.78 | 1.00 | 0 | 0 | 0 |
| Boron nitride particles in aqueous suspension⁴³ | 0 | 0 | 74.78 | 1.00 | 0 |

| | | | | | |
|---|---|---|---|---|---|
| ³⁴ EPON 826 which is commercially available from Shell Chemical of Houston, Texas. | | | | | |
| ³⁵ PVP K-30 polyvinyl pyrrolidone which is commercially available from ISP Chemicals of Wayne, New Jersey. | | | | | |
| ³⁶ ALKAMULS EL-719 polyoxyethylated vegetable oil which is commercially available from Rhone-Poulenc. | | | | | |
| ³⁷ IGEPAL CA-630 ethoxylated octylphenoxyethanol which is commercially available from GAF Corporation of Wayne, New Jersey. | | | | | |
| ³⁸ KESSCO PEG 600 polyethylene glycol monolaurate ester which is commercially available from Stepan Company of Chicago, Illinois. | | | | | |
| ³⁹ A-187 gamma-glycidoxypropyltrimethoxysilane which is commercially available from OSi Specialties, Inc. of Tarrytown, New York. | | | | | |
| ⁴⁰ EMERY® 6717 partially amidated polyethylene imine which is commercially available from Henkel Corporation of Kankakee, Illinois. | | | | | |
| ⁴¹ Protolube HD high density polyethylene emulsion which is commercially available from Sybron Chemicals of Birmingham, New Jersey. | | | | | |
| ⁴² PolarTherm® PT 160 boron nitride powder particles which are commercially available from Advanced Ceramics Corporation of Lakewood, Ohio. | | | | | |
| ⁴³ ORPAC BORON NITRIDE RELEASECOAT-CONC boron nitride particles in aqueous dispersion which is commercially available from ZYP Coatings, Inc. of Oak Ridge, Tennessee. | | | | | |

Each coated glass fiber strand was twisted to form yarn and wound onto bobbins in a similar manner using conventional twisting equipment. The yarns of Samples F and H exhibited minimal sizing shedding during twisting and the yarns of Samples E and G exhibited severe sizing shedding during twisting.

The yarns of Samples E-H and Comparative Sample were evaluated for Air Drag in a similar manner to Example 1 above, except that the Air Drag values were determined for two bobbin samples at the pressures indicated in Table 4. Each yarn was evaluated for average number of broken filaments per 1200 meters of yarn at 200 meters per minute using a Shirley Model No. 84 041 L broken filament detector, which is commercially available from SDL International Inc. of England. These values represent the average of measurements conducted on four bobbins of each yarn. The broken filament values are reported from sections taken from a full bobbin, 136 grams (3/10 pound) and 272 grams (6/10 pound) of yarn unwound from the bobbin.

Each yarn was also evaluated for Gate Tension testing are set forth in Table 4 below. The number of broken filaments measured according to the Gate Tension Method is determined by unwinding a sample of yarn from a bobbin at 200 meters/minute, threading the yarn through a series of 8 parallel ceramic pins and passing the yarn through the Shirley broken filament detector discussed above to count the number of broken filaments.

**TABLE 4**

| NUMBER OF BROKEN FILAMENTS PER METER OF YARN | | Sample E | Sample F | Sample G | Sample H | Comp. Sample |
|---|---|---|---|---|---|---|
| full bobbin | | 0.887 | 0.241 | greater than 10 | 0.065 | 0.192 |
| 136 grams (3/10 pound) | | 0.856 | 0.017 | greater than 10 | 0.013 | 0.320 |
| 272 grams (6/10 pound) | | 0.676 | 0.030 | greater than 10 | 0.101 | 0.192 |

| GATE TENSION (number of hairs per meter) | | | | | | |
|---|---|---|---|---|---|---|
| Gate 2 | | - | 0.039 | - | 0.0235 | 0.721 |
| Gate 3 | | - | 0.025 | - | 0.028 | 0.571 |
| Gate 4 | | - | 0.0125 | - | 0.068 | 0.4795 |
| Gate 5 | | - | 0.015 | - | 0.093 | 0.85 |
| Gate 6 | | - | 0.0265 | - | 0.118 | 0.993 |
| Gate 7 | | - | 0.0695 | - | 0.31 | 1.0835 |
| Gate 8 | | - | 0.117 | - | 0.557 | 1.81 |

| AIR DRAG (grams) | | | | | | |
|---|---|---|---|---|---|---|
| 25 psi | Bobbin 1 | - | 10.420 | - | 10.860 | 11.610 |
| | Bobbin 2 | - | 10.600 | - | 7.850 | 11.610 |
| 30 psi | Bobbin 1 | - | 11.690 | - | 12.500 | 13.680 |
| | Bobbin 2 | - | 12.200 | - | 8.540 | 13.850 |
| 35 psi | Bobbin 1 | - | 13.490 | - | 14.030 | 15.880 |
| | Bobbin 2 | - | 13.530 | - | 9.570 | 15.630 |
| 40 psi | Bobbin 1 | - | 14.740 | - | 14.110 | 17.560 |
| | Bobbin 2 | - | 14.860 | - | 11.010 | 17.610 |
| 45 psi | Bobbin 1 | - | 16.180 | - | 16.390 | 19.830 |
| | Bobbin 2 | - | 16.680 | - | 12.700 | 18.950 |
| 50 psi | Bobbin 1 | - | 17.510 | - | 19.280 | 22.410 |
| | Bobbin 2 | - | 17.730 | - | 14.000 | 20.310 |
| 55 psi | Bobbin 1 | - | 19.570 | - | 23.350 | 29.350 |
| | Bobbin 2 | - | 19.660 | - | 20.250 | 26.580 |

While the test results presented in Table 4 appear to indicate that Samples E-H according to the present invention had generally higher abrasion resistance than the Comparative Sample, it is believed that these results are not conclusive since it is believed that a polyethylene emulsion component of the Comparative Sample, which was not present in Samples E-H, contributed to abrasive properties of the yarn.

### EXAMPLE 3

Each of the components in the amounts set forth in Table 5 were mixed to form aqueous forming size compositions K through N according to the present invention. Each aqueous forming size composition was prepared in a similar manner to that discussed above. Less than about 1 weight percent of acetic acid on a total weight basis was included in each composition.

Each of the aqueous forming size compositions of Table 5 was coated onto 2G-18 E-glass fiber strands. Each of the forming size compositions had about 10 weight percent solids.

**Table 5**

| | WEIGHT PERCENT OF COMPONENT ON TOTAL SOLIDS BASIS | | | | |
|---|---|---|---|---|---|
| | Sample No. | | | | |
| COMPONENT | K | L | M | N | Comparative Sample |
| Thermoplastic polyurethane film-forming polymer⁴⁴ | 34.4 | 34.2 | 33.4 | 31.35 | 34.5 |
| Thermoplastic polyurethane film-forming polymer⁴⁵ | 51.5 | 51.2 | 50.18 | 46.9 | 51.7 |
| polyoxyalkylene polyol copolymer | 0.3 | 0.3 | 0.3 | 0.3 | 0.33 |
| epoxidized polyester lubricant | 7.2 | 7.1 | 7.0 | 6.55 | 7.22 |
| Gamma-aminopropyl triethoxysilane coupling agent | 2.7 | 2.7 | 2.7 | 2.5 | 2.76 |
| Gamma-ureidopropyl triethoxysilane coupling agent | 3.3 | 3.3 | 3.2 | 3.0 | 3.34 |
| amino-functional organo silane coupling agent | 0.1 | 0.1 | 0.1 | 0.1 | 0.14 |
| Boron nitride particles in aqueous suspension⁴⁶ | 0.1 | 1.0 | 2.9 | 9.1 | 0 |
| loss on ignition (%) | 1.11 | 1.14 | 1.05 | 1.08 | 1.17 |

| | | | | | |
|---|---|---|---|---|---|
| ⁴⁴ Thermoplastic polyester-based polyurethane aqueous emulsion having 65 percent solids, anionic particle charge, particle size of about 2 micrometers, a pH of 7.5 and a viscosity of 400 centipoise (Brookfield LVF) at 25°C. | | | | | |
| ⁴⁵ Thermoplastic polyester-based polyurethane aqueous dispersion having a solids content of 62 percent, pH of about 10 and average particle size ranging from about 0.8 to about 2.5 microns. | | | | | |
| ⁴⁶ ORPAC BORON NITRIDE RELEASECOAT-CONC boron nitride particles in aqueous dispersion which is commercially available from ZYP Coatings, Inc. of Oak Ridge. Tennessee. | | | | | |

Composite samples of each of the above coated glass fiber samples and the Comparative Sample were extrusion molded at 270°C for 48 seconds at about 7 MPa (975 psi) to produce 254 x 254 x 3.175 millimeters (10 x 10 x 0.125 inches) plaques. Each specimen was evaluated for: tensile strength, tensile elongation and tensile modulus according to ASTM Method D-638M; flexural strength and flexural modulus according to ASTM Method D-790; and notched and unnotched Izod impact strength according to ASTM Method D-256 at the glass contents specified below.

Table 6 presents the results of tests conducted on composites formed using a conventional nylon 6,6 matrix resin.

**TABLE 6**

| | units | K | L | M | N | Comp. Sample |
|---|---|---|---|---|---|---|
| Tensile Strength | kpsi | 27.1 | 27.6 | 27.3 | 27.4 | 26.2 |
| | MPa | 186.9 | 190.34 | 188.27 | 188.96 | 180.68 |
| Tensile Elongation | % | 3.32 | 3.37 | 3.36 | 3.42 | 3.32 |
| Tensile Modulus | mpsi | 1.48 | 1.55 | 1.47 | 1.44 | 1.51 |
| | GPa | 10.2 | 10.7 | 10.1 | 9.9 | 10.4 |
| Flexural Strength | kpsi | 44.6 | 46.3 | 45.7 | 45.5 | 44.0 |
| | MPa | 307.6 | 319.3 | 315.2 | 313.8 | 303.4 |
| Flexural Modulus | mpsi | 1.52 | 1.56 | 1.54 | 1.54 | 1.5 |
| | GPa | 10.5 | 10.7 | 10.6 | 10.6 | 10.6 |
| notched IZOD Impact | ft lb_{f}/in | 1.86 | 2.24 | 1.94 | 1.63 | 1.16 |
| | kJ/m² | 7.89 | 9.50 | 8.23 | 6.91 | 4.92 |
| unnotched IZOD Impact | ft lb_{f}/in | 21.8 | 22.9 | 21.1 | 20.5 | 22.0 |
| | kJ/m² | 92.43 | 97.10 | 89.46 | 86.92 | 93.28 |
| Glass content | % | 32.9 | 32.6 | 32.4 | 32.3 | 32.4 |

As shown in Table 6, glass fiber strands coated with boron nitride particles (Samples K-N) according to the present invention exhibit improved tensile strength and notched Izod impact properties and similar tensile elongation and modulus, flexural strength and modulus and unnotched Izod impact properties when compared to a comparative sample having similar components which did not contain boron nitride in nylon 6,6 reinforcement. When evaluated using nylon 6 resin under similar conditions, the improvements in tensile strength and notched Izod impact properties were not observed.

### EXAMPLE 4

Each of the components in the amounts set forth in Table 7 were mixed to form aqueous forming size compositions P through S according to the present invention. Each aqueous forming size composition was prepared in a similar manner to that discussed above. Less than about 1 weight percent of acetic acid on a total weight basis was included in each composition.

Each of the aqueous forming size compositions of Table 7 was coated onto G-31 E-glass fiber strands. Each of the forming size compositions had about 10 weight percent solids.

**Table 7**

| | WEIGHT PERCENT OF COMPONENT ON TOTAL SOLIDS BASIS | | | |
|---|---|---|---|---|
| | Sample No. | | | |
| COMPONENT | P | Q | R | S |
| Thermoplastic polyurethane film-forming polymer⁴⁷ | 23 | 28.75 | 28.75 | 23 |
| Thermoplastic polyurethane film-forming polymer⁴⁸ | 34.45 | 43.1 | 43.1 | 34.45 |
| polyoxyalkylene polyol copolymer | 0.22 | 0.27 | 0.27 | 0.22 |
| epoxidized polyester lubricant | 4.8 | 6.0 | 6.0 | 4.8 |
| Gamma-aminopropyl triethoxysilane coupling agent | 1.84 | 2.3 | 2.3 | 1.84 |
| Gamma-ureidopropyl triethoxysilane coupling agent | 2.22 | 2.78 | 2.78 | 2.22 |
| amino-functional organo silane coupling agent | 0.1 | 0.12 | 0.12 | 0.1 |
| Boron nitride powder particles⁴⁹ | 33.3 | 16.7 | 0 | 0 |
| talc powder particles⁵⁰ | 0 | 0 | 16.7 | 33.3 |
| loss on ignition (%) | 0.52 | 0.81 | 0.80 | 0.64 |

| | | | | |
|---|---|---|---|---|
| ⁴⁷ Thermoplastic polyester-based polyurethane aqueous emulsion having 65 percent solids, anionic particle charge, particle size of about 2 micrometers, a pH of 7.5 and a viscosity of 400 centipoise (Brookfield LVF) at 25°C. | | | | |
| ⁴⁸ Thermoplastic polyester-based polyurethane aqueous dispersion having a solids content of 62 percent, pH of about 10 and average particle size ranging from about 0.8 to about 2.5 microns. | | | | |
| ⁴⁹ PolarTherm® PT 160 boron nitride powder particles which are commercially available from Advanced Ceramics Corporation of Lakewood, Ohio. | | | | |
| ⁵⁰ VANTALC 2003 talc powder particles which are commercially available from R.T. Vanderbilt Company, Inc. of Norwalk, Connecticut. | | | | |

Composite samples of each of the above coated glass fiber samples and the Comparative Sample of Table 5 above were extrusion molded to produce 400 x 400 x 2.5 millimeters (16 x 16 x 0.100 inches) plaques under the conditions set forth in Example 3 above. Each specimen was evaluated for: tensile strength, tensile elongation, tensile modulus, notched and unnotched Izod impact strength as discussed in Example 3 above at the glass contents specified below.

The color tests were performed on composites having a thickness of 3.175 millimeters (1/8 inch) and a diameter of 76.2 millimeters (3 inches) using a Hunter colorimeter Model D25-PC2A. To evaluate material handling characteristics, funnel flow tests were conducted on samples of chopped glass fiber. The funnel was eighteen inches long and had a seventeen inch diameter opening at the top and a two inch opening on the bottom. The funnel was vibrated and the time was recorded for 20 pounds of sample material to flow through the funnel. The PD-104 test evaluates the resistance of the chopped glass fiber sample to filamentation. Sixty grams of sample, 140 grams of an abrasive material (ground walnut shell particles No. 6/10 which are commercially available from Hammon Products Company) and a conventional foam-type antistatic dryer sheet were enclosed in a 4 liter stainless steel beaker and vibrated using a Red Devil paint shaker Model 5400E3 for six minutes. The vibrated material was screened using No. 5 and No. 6 U.S. Standard testing sieves. The weight percent of fuzz material collected on the screens as a percentage of original sample is reported below.

Table 8 presents the results of tests conducted on composites formed using Samples P-S and the Comparative Sample using nylon 6,6 matrix resin.

**TABLE 8**

| | units | P | Q | R | S | Comp. Sample |
|---|---|---|---|---|---|---|
| Tensile Strength | kpsi | 29.5 | 28.6 | 28.7 | 27.7 | 29.6 |
| | MPa | 203.5 | 197.2 | 197.9 | 191.0 | 204.1 |
| Tensile Elongation | % | 3.03 | 3.05 | 2.98 | 2.97 | 3.01 |
| Tensile Modulus | kpsi | 1866 | 1779 | 1720 | 1741 | 1748 |
| | GPa | 12.86 | 12.26 | 11.86 | 12.0 | 12.05 |
| notched IZOD Impact | ft lb_{f}/in | 2.10 | 1.96 | 1.94 | 1.78 | 2.26 |
| | kJ/m² | 8.90 | 8.31 | 8.23 | 7.55 | 9.58 |
| unnotched IZOD Impact | ft lb_{f}/in | 24.9 | 23.4 | 22.8 | 22.2 | 26.4 |
| | kJ/m² | 105.58 | 99.22 | 96.67 | 94.13 | 111.94 |
| Actual Loss on Ignition | % | 0.81 | 0.52 | 0.80 | 0.64 | 1.17 |
| PD 104 | % | 1.3 | 0.7 | 0.1 | 1.4 | 0.1 |
| Funnel Flow | seconds | 13.8 | 15.2 | 15.4 | 23.5 | 13.0 |
| Whiteness Index | | -15.1 | -12.0 | -17.6 | -18.5 | -18.2 |
| Yellowness Index | | 40.0 | 37.5 | 42.5 | 43.4 | 43.6 |
| Glass content | % | 33.30 | 33 | 32.90 | 31.70 | 33.80 |

As shown in Table 8, glass fiber strands coated with boron nitride particles (Samples P-S) according to the present invention exhibit improved whiteness and yellowness and similar tensile strength, elongation and modulus, flexural strength and modulus, and notched and unnotched Izod impact properties when compared to a Comparative Sample having similar components which did not contain boron nitride in nylon 6,6 reinforcement.

### EXAMPLE 5

Each of the components in the amounts set forth in Table 9 were mixed to form aqueous forming size compositions T and U according to the present invention. Each aqueous forming size composition was prepared in a similar manner to that discussed above. Less than about 1 weight percent of acetic acid on a total weight basis was included in each composition. Table 9 presents the results of whiteness and yellowness tests conducted on composites formed using Samples T, U and the Comparative Sample using nylon 6,6 matrix resin. The color tests were performed on composites having a thickness of 3.175 millimeters (1/8 inch) and a diameter of 76.2 millimeters (3 inches) using a Hunter colorimeter Model D25-PC2A.

**Table 9**

| | WEIGHT PERCENT OF COMPONENT ON TOTAL SOLIDS BASIS | | |
|---|---|---|---|
| | Sample No. | | |
| COMPONENT | T | U | Comparative Sample |
| Thermoplastic polyurethane film-forming polymer⁵¹ | 31.35 | 28.75 | 34.4 |
| Thermoplastic polyurethane film-forming polymer⁵² | 46.9 | 43.1 | 51.6 |
| polyoxyalkylene polyol copolymer | 0.3 | 0.27 | 0.3 |
| epoxidized polyester lubricant | 6.55 | 6.0 | 7.2 |
| Gamma-aminopropyl triethoxysilane coupling agent | 2.5 | 2.3 | 2.7 |
| Gamma-ureidopropyl triethoxysilane coupling agent | 3.0 | 2.78 | 3.3 |
| amino-functional organo silane coupling agent | 0.1 | 0.12 | 0.1 |
| Boron nitride particles in aqueous suspension⁵³ | 9.1 | 16.7 | 0 |
| Whiteness Index | -16.3 | -15.0 | -20.7 |
| Yellowness Index | 39.3 | 38.1 | 42.7 |

| | | | |
|---|---|---|---|
| ⁵¹ Thermoplastic polyester-based polyurethane aqueous emulsion having 65 percent solids, anionic particle charge, particle size of about 2 micrometers, a pH of 7.5 and a viscosity of 400 centipoise (Brookfield LVF) at 25°C. | | | |
| ⁵² Thermoplastic polyester-based polyurethane aqueous dispersion having a solids content of 62 percent, pH of about 10 and average particle size ranging from about 0.8 to about 2.5 microns. | | | |
| ⁵³ ORPAC BORON NITRIDE RELEASECOAT-CONC boron nitride particles in aqueous dispersion which is commercially available from ZYP Coatings. Inc. of Oak Ridge. Tennessee. | | | |

As is shown in Table 9, Samples T and U, each coated with a sizing composition containing boron nitride particles according to the present invention, had lower whiteness indices in nylon 6,6 than a Comparative Sample of a similar formulation which did not include boron nitride.

### EXAMPLE 6

Five layers of ADFLO-C™ needled chopped glass fiber mat, which is commercially available from PPG Industries, Inc., were stacked to form a mat having a surface weight of about 4614 grams per square meter (15 ounces per square foot). The thickness of each sample was about 25 millimeters (about 1 inch). Four eight-inch square samples of this mat were heated to a temperature of about 649°C (about 1200°F) to remove essentially all of the sizing components from the samples.

Two uncoated samples were used as comparative samples. The other two samples were dipped and saturated in a bath of an aqueous coating composition consisting of 1150 milliliters of ORPAC BORON NITRIDE RELEASECOAT-CONC (25 weight percent boron nitride particles in an aqueous dispersion) and 150 milliliters of a 5 weight percent aqueous solution of A-187 gamma-glycidoxypropyltrimethoxysilane. The total solids of the aqueous coating composition was about 18.5 weight percent. The amount of boron nitride particles applied to each mat sample was about 120 grams. The coated mat samples were dried in air overnight at a temperature of about 25°C and heated in an oven at about 150°C for about three hours.

Each set of samples was evaluated for thermal conductivity and thermal resistance in air at temperatures of about 300K (about 70°F) according to ASTM Method C-177, which is hereby incorporated by reference. The values for thermal conductivity and thermal resistance for each sample are set forth in Table 10 below.

**Table 10**

| | **Sample** | |
|---|---|---|
| | **X** | **Comp. Sample** |
| **Thickness** (inches) | 1.09 | 1.0 |
| (centimeters) | 2.77 | 2.54 |
| **Temperature** (°F) | 75.62 | 74.14 |
| (°C) | 24.23 | 23.41 |
| **Thermal conductivity** | | |
| Btu inches per hour square feet°F | 0.373 | 0.282 |
| Watts per meter K | 0.054 | 0.041 |
| **Thermal resistance** | | |
| Hour square feet °F per BTU | 2.92 | 3.55 |
| meter² K per Watts | 0.515 | 0.626 |

Referring to Table 10, the thermal conductivity at a temperature about 300K of the test sample coated with boron nitride particles according to the present invention was greater than the thermal conductivity of the Comparative Sample which was not coated with boron nitride particles.

### EXAMPLE 7

Filament wound cylindrical composites were prepared from samples of G-75 yarn coated with sizing G of Example 2 above and 1062 glass fiber yarn which is commercially available from PPG Industries, Inc. The cylinders were prepared by drawing eight ends of yarn from a yarn supply, coating the yarn with the matrix materials set forth below, and filament winding the yarn into a cylindrical shape using a conventional filament winding apparatus. Each of the cylinders was 12.7 centimeters (5 inches) high, had an internal diameter of 14.6 centimeters (5.75 inches) and a wall thickness of 0.635 centimeters (0.25 inches).

The matrix materials were a mixture of 100 parts EPON 880 epoxy resin (commercially available from Shell Chemical), 80 parts AC-220J methyl tetrahydro phthalic anhydride (commercially available from Anhydrides and Chemicals, Inc. of Newark, New Jersey), and 1 part ARALDITE® DY 062 benzyl dimethyl amine accelerator (commercially available from Ciba-Geigy). The filament wound cylinders were cured for two hours at 100°C and then for three hours at 150°C.

The radial thermal diffusivity (thermal conductivity/(heat capacity x density)) of each test sample in air was determined by exposing one side of the cylinder wall of the sample to a 6.4 kJ flash lamp and sensing the temperature change on the opposite side of the wall using a CCD array infrared camera at a rate of up to 2000 frames per second. Thermal diffusivity values were also determined along a length of the yarn (circumferential) and along a length or height of the cylinder (axial). The test results are set forth below in Table 11.

**Table 11**

| | **Thermal Diffusivity (mm**^{**2**}**/sec)** | | |
|---|---|---|---|
| | **radial** | **axial** | **circumferential** |
| Sample | 0.37 | 0.33 | 0.49 |
| Comparative Sample | 0.38 | 0.38 | 0.57 |

Referring to Table 11, the values of thermal diffusivity for the test sample (which was coated with a small amount of boron nitride) are less than those of the comparative sample, which was not coated with boron nitride. Air voids in the filament wound cylinder and the small sample area tested are factors which may have influenced these results.

From the foregoing description, it can be seen that the present invention provides methods for inhibiting abrasive wear of glass fiber strands by providing an abrasion-resistant coating which provides good thermal stability, low corrosion and reactivity in the presence of high humidity, reactive acids and alkalies and compatibility with a variety of polymeric matrix materials. These strands can be twisted or chopped, formed into a roving, chopped mat or continuous strand mat or woven or knitted into a fabric for use in a wide variety of applications, including reinforcements for composites such as printed circuit boards.

## Claims

1. A method for inhibiting abrasive wear of a glass fiber strand comprising at least one glass fiber by sliding contact with surface asperities of a solid object, comprising the steps of:
(a) applying a primary layer of a first aqueous sizing or coating composition comprising a polymeric material and inorganic solid lubricant particles to at least a portion of a surface of at least one glass fiber of a glass fiber strand;
(b) at least partially drying the first aqueous sizing or coating composition of the primary layer to form a sized glass fiber strand having a generally uniform coating of the aqueous sizing or coating composition upon the portion of the surface of the at least one glass fiber; and
(c) sliding at least a portion of the glass fiber strand to contact surface asperities of a solid object, the surface asperities having a hardness value which is greater than a hardness value of the at least one glass fiber, such that abrasive wear of the at least one glass fiber of the glass fiber strand by contact with the surface asperities of the solid object is inhibited by the inorganic solid lubricant particles.

2. The method according to claim 1, wherein the first aqueous sizing or coating composition used in step (a) comprising a glass fiber coupling agent instead of a polymeric material.

3. The method according to claim 1, wherein the first aqueous sizing and coating composition is applied to at least a portion of sized surfaces of at least one glass fiber of a glass fiber strand forming a principal layer in step (a).

4. A method for inhibiting abrasive wear of a glass fiber strand comprising at least one sized and secondarily coated glass fiber by sliding contact with surface asperities of a solid object, comprising the steps of:
(a) applying a principal layer comprising powdered non-hydratable, lamellar inorganic solid lubricant particles to at least a portion of a sized and secondarily coated surface of at least one glass fiber of a glass fiber strand; and
(b) sliding at least a portion of the glass fiber strand to contact surface asperities of a solid object, the surface asperities having a hardness value which is greater than a hardness value of the at least one glass fiber, such that abrasive wear of the at least one glass fiber of the glass fiber strand by contact with the surface asperities of the solid object is inhibited by the inorganic solid lubricant particles.

5. The method according to claims 1 or 2, wherein the first aqueous sizing or coating composition comprising lamellar boron nitride particles, thermosetting polyester film-forming material, polyvinyl pyrrolidone and an epoxy-functional organo silane coupling agent.

6. The method according to any of claims 1 to 5 wherein the at least one glass fiber is selected from the group consisting of E-glass fibers, D-glass fibers, S-glass fibers, Q-glass fibers, E-glass derivative fibers, and combinations thereof.

7. The method according to claim 6 wherein the at least one glass fiber is an E-glass fiber.

8. The method according to claim 7, wherein the at least one glass fiber is an E-glass derivative fibers.

9. The method according to any of claims 1 to 5, wherein at least one of the at least one glass fiber is formed from a fiberizable material selected from the group consisting of non-glass inorganic materials, natural materials, organic polymeric materials and combinations thereof.

10. The method according to claim 1, wherein the polymeric material comprises at least one material selected from the group consisting of thermosetting materials, thermoplastic materials and mixtures thereof.

11. The method according to claim 10, wherein the polymeric material comprises at least one thermosetting material selected from the group consisting of thermosetting polyesters, vinyl esters, epoxy materials, phenolics, aminoplasts, thermosetting polyurethanes and mixtures thereof.

12. The method according to claim 10, wherein the polymeric material comprises at least one thermoplastic material selected from the group consisting of vinyl polymers, thermoplastic polyesters, polyolefins, polyamides, thermoplastic polyurethanes, acrylic polymers and mixtures thereof.

13. The method according to claim 12, wherein the thermoplastic material is a thermoplastic polyester.

14. The method according to claim 12, wherein the thermoplastic material is a polyvinyl pyrrolidone.

15. The method according to any of claims 1, 2 or 3, wherein the inorganic solid lubricant particles have a lamellar structure.

16. The method according to any of claims 1, 2 or 3, wherein the inorganic solid lubricant particles comprise at least one particle selected from the group consisting of non-hydratable inorganic solid lubricant particles, hydratable inorganic solid lubricant particles and mixtures thereof.

17. The method according to claim 16, wherein the non-hydratable inorganic solid lubricant particles comprise at least one particle selected from the group consisting of graphite, boron nitride, metal dichalcogenides, cadmium iodide, silver sulfide and mixtures thereof.

18. The method according to claim 17, wherein the non-hydratable inorganic solid lubricant particles comprise at least one particle selected from the group consisting of boron nitride, metal dichalcogenides, cadmium iodide, silver sulfide and mixtures thereof.

19. The method according to claim 18, wherein the non-hydratable inorganic solid lubricant particles comprise hexagonal crystal structure boron nitride particles.

20. The method according to claim 18, wherein the non-hydratable inorganic solid lubricant particles comprise at least one metal dichalcogenide selected from the group consisting of molybdenum disulfide, molybdenum diselenide, tantalum disulfide, tantalum diselenide, tungsten disulfide, tungsten diselenide and mixtures thereof.

21. The method according to claim 16, wherein the non-hydratable inorganic solid lubricant particles comprise at least one particle selected from the group consisting of indium, thallium, tin. copper, zinc, gold, silver, calcium carbonate, calcium fluoride, zinc oxide and mixtures thereof.

22. The method according to claim 16, wherein the hydratable inorganic solid lubricant particles comprise phyllosilicates.

23. The method according to claim 22, wherein the phyllosilicates comprise at least one phyllosilicate selected from the group consisting of mica, talc, gypsum, kaolinite, montmorillonite and mixtures thereof.

24. The method according to claim 16, wherein the aqueous sizing composition is essentially free of hydratable inorganic solid lubricant particles.

25. The method according to any of claims 1, 2 or 3, wherein the hardness value of the inorganic solid lubricant particles is less than or equal to the hardness value of the at least one glass fiber.

26. The method according to claim 25, wherein the inorganic solid lubricant particles have a Mohs' hardness value ranging from 1 to 6.

27. The method according to any of claims 1, 2 or3, wherein the average size of the inorganic lubricant particles is less than 1000 micrometers.

28. The method according to any of claims 1, 2 or 3, wherein the inorganic solid lubricant particles are thermally conductive.

29. The method according to any of claims 1, 2 or 3, wherein the inorganic solid lubricant particles are electrically insulative.

30. The method according to any of claims 1, 2 or 3, wherein the inorganic solid lubricant particles comprise 0.001 to 99 weight percent of the first aqueous sizing or coating composition on a total solids basis.

31. The method according to any of claims 1, 2 or 3, wherein the sizing composition comprises less than 20 volume percent of glass materials.

32. The method of any of claims 1 to5, wherein the solid surface in step(c)is surface asperities of a portion of a fabric assembly device, the surface asperities having a hardness value which is greater than a hardness value of glass fibers of the first glass fiber strand; and (d) interweaving the first glass fiber strand with a second fiber strand to form a fabric.

33. The method according to claim 32, wherein the fabric assembly device is selected from the group consisting of a loom and a knitting device.

## Patentansprüche

1. Verfahren zum Verhindern von Verschleiß eines Glasfaserstranges durch Abrieb, der mindestens eine Glasfaser enthält, durch Gleitkontakt mit Oberflächenunebenheiten eines festen Gegenstandes, mit den Schritten:
(a) Aufbringen einer ersten Schicht einer ersten wässrigen Schlicht- oder Beschichtungszusammensetzung, die ein polymeres Material und anorganische feste Gleitmittelteilchen enthält, auf mindestens einen Teil einer Oberfläche mindestens einer Glasfaser eines Glasfaserstranges,
(b) mindestens teilweises Trocknen der ersten wässrigen Schlicht- oder Beschichtungszusammensetzung der ersten Schicht, um einen geschlichteten Glasfaserstrang auszubilden, der eine im allgemeinen gleichmäßige Beschichtung der wässrigen Schlicht- oder Beschichtungszusammensetzung auf dem Teil der Oberfläche mindestens einer Glasfaser aufweist, und
(c) Gleiten mindestens eines Teils des Glasfaserstranges in Kontakt mit Oberflächenunebenheiten eines festen Gegenstandes, wobei die Oberflächenunebenheiten einen Härtewert aufweisen, der größer ist als ein Härtewert der mindestens einen Glasfaser, so dass Verschleiß mindestens einer Glasfaser des Glasfaserstranges durch Abrieb bei Kontakt mit den Oberflächenunebenheiten eines festen Gegenstandes durch die anorganischen festen Gleitmittelteilchen verhindert wird.

2. Verfahren nach Anspruch 1, **dadurch gekennzeichnet, dass** die erste wässrige Schlicht- oder Beschichtungszusammensetzung, die in Schritt (a) verwendet wird, anstelle eines polymeren Materials ein Glasfaserkupplungsmittel enthält.

3. Verfahren nach Anspruch 1, **dadurch gekennzeichnet, dass** die erste wässrige Schlicht- und Beschichtungszusammensetzung auf mindestens einen Teil von mit Schlichte versehenen Oberflächen mindestens einer Glasfaser eines Glasfaserstranges aufgebracht wird und eine Hauptschicht in Schritt (a) ausgebildet wird.

4. Verfahren zum Verhindern von Verschleiß eines Glasfaserstranges durch Abrieb, der mindestens eine geschlichtete und sekundär beschichtete Glasfaser enthält, durch Gleitkontakt mit Oberflächenunebenheiten eines festen Gegenstandes mit den Schritten:
(a) Aufbringen einer Hauptschicht enthaltend pulverförmige nichtwasseraufnehmende blättchenförmige anorganische feste Gleitmittelteilchen auf mindestens einen Teil einer geschlichteten und sekundär beschichteten Oberfläche mindestens einer Glasfaser eines Glasfaserstranges und
(b) Gleiten mindestens eines Teils des Glasfaserstranges in Kontakt mit Oberflächenunebenheiten eines festen Gegenstandes, wobei die Oberflächenunebenheiten einen Härtewert aufweisen, der größer ist als ein Härtewert der mindestens einen Glasfaser, so dass Verschleiß mindestens einer Glasfaser des Glasfaserstranges durch Abrieb bei Kontakt mit den Oberflächenunebenheiten eines festen Gegenstandes durch die anorganischen festen Gleitmittelteilchen verhindert wird.

5. Verfahren nach Ansprüchen 1 oder 2, **dadurch gekennzeichnet, dass** die erste wässrige Schlicht- oder Beschichtungszusammensetzung blättchenförmige Bornitridteilchen, filmbildendes wärmehärtendes Polyestermaterial, Polyvinylpyrrolidon und ein Epoxygruppen aufweisendes Organosilankupplungsmittel enthält.

6. Verfahren nach einem der Ansprüche 1 bis 5, **dadurch gekennzeichnet, dass** die mindestens eine Glasfaser aus der aus E-Glasfasern, D-Glasfasern, S-Glasfasern, Q-Glasfasern, E-Glasfaserderivatfasern und Kombinationen derselben bestehenden Gruppe ausgewählt ist.

7. Verfahren nach Anspruch 6, **dadurch gekennzeichnet, dass** die mindestens eine Glasfaser eine E-Glasfaser ist.

8. Verfahren nach Anspruch 7, **dadurch gekennzeichnet, dass** die mindestens eine Glasfaser eine E-Glasfaserderivatfaser ist.

9. Verfahren nach einem der Ansprüche 1 bis 5, **dadurch gekennzeichnet, dass** mindestens eine der Glasfasern aus einem zu Fasern verarbeitbaren Material ausgebildet ist, ausgewählt aus der Gruppe bestehend aus anorganischen Materialien, die nicht Glas sind, natürlichen Materialien, organischen polymeren Materialien und Kombinationen derselben.

10. Verfahren nach Anspruch 1, **dadurch gekennzeichnet, dass** das polymere Material mindestens ein Material enthält, das aus der aus wärmehärtenden Materialien, thermoplastischen Materialien und Mischungen derselben bestehenden Gruppe ausgewählt ist.

11. Verfahren nach Anspruch 10, **dadurch gekennzeichnet, dass** das polymere Material mindestens ein wärmehärtendes Material enthält, das aus der aus wärmehärtenden Polyestern, Vinylestern, Epoxymaterialien, phenolischen Materialien, Aminoplasten, wärmehärtenden Polyurethanen und Mischungen derselben bestehenden Gruppe ausgewählt ist.

12. Verfahren nach Anspruch 10, **dadurch gekennzeichnet, dass** das polymere Material mindestens ein thermoplastisches Material enthält, das aus der aus Vinylpolymeren, thermoplastischen Polyestern, Polyolefinen, Polyamiden, thermoplastischen Polyurethanen, Acrylpolymeren und Mischungen derselben bestehenden Gruppe ausgewählt ist.

13. Verfahren nach Anspruch 12, **dadurch gekennzeichnet, dass** das thermoplastische Material ein thermoplastischer Polyester ist.

14. Verfahren nach Anspruch 12, **dadurch gekennzeichnet, dass** das thermoplastische Material ein Polyvinylpyrrolidon ist.

15. Verfahren nach einem der Ansprüche 1, 2 oder 3, **dadurch gekennzeichnet, dass** die anorganischen festen Gleitmittelteilchen eine blättchenförmige Struktur aufweisen.

16. Verfahren nach einem der Ansprüche 1, 2 oder 3, **dadurch gekennzeichnet, dass** die anorganischen festen Gleitmittelteilchen mindestens ein Teilchen enthalten, das aus der aus nichtwasseraufnehmenden anorganischen festen Gleitmittelteilchen, wasseraufnehmenden anorganischen festen Gleitmittelteilchen und Mischungen derselben bestehenden Gruppe ausgewählt ist.

17. Verfahren nach Anspruch 16, **dadurch gekennzeichnet, dass** die nichtwasseraufnehmenden anorganischen festen Gleitmittelteilchen mindestens ein Teilchen enthalten, das aus der aus Graphit, Bornitrid, Metalldichalkogeniden, Cadmiumjodid, Silbersulfid und Mischungen derselben bestehenden Gruppe ausgewählt ist.

18. Verfahren nach Anspruch 17, **dadurch gekennzeichnet, dass** die nichtwasseraufnehmenden anorganischen festen Gleitmittelteilchen mindestens ein Teilchen enthalten, das aus der aus Bornitrid, Hetalldichalkogeniden, Cadmiumjodid, Silbersulfid und Mischungen derselben bestehenden Gruppe ausgewählt ist.

19. Verfahren nach Anspruch 18, **dadurch gekennzeichnet, dass** die nichtwasseraufnehmenden anorganischen festen Gleitmittelteilchen hexagonale Kristallstruktur aufweisende Bornitridteilchen sind.

20. Verfahren nach Anspruch 18, **dadurch gekennzeichnet, dass** die nichtwasseraufnehmenden anorganischen festen Gleitmittelteilchen mindestens ein Metalldichalkogenid enthalten, das aus der aus Molybdändisulfid, Molybdändiselenid, Tantaldisulfid, Tantaldiselenid, Wolframdisulfid, Wolframdiselenid und Mischungen derselben bestehenden Gruppe ausgewählt ist.

21. Verfahren nach Anspruch 16, **dadurch gekennzeichnet, dass** die nichtwasseraufnehmenden anorganischen festen Gleitmittelteilchen mindestens ein Teilchen enthalten, das aus der aus Indium, Thallium, Zinn, Kupfer, Zink, Gold, Silber, Calciumcarbonat, Calciumfluorid, Zinkoxid und Mischungen derselben bestehenden Gruppe ausgewählt ist.

22. Verfahren nach Anspruch 16, **dadurch gekennzeichnet, dass** die wasseraufnehmenden anorganischen festen Gleitmittelteilchen Phyllosilicate sind.

23. Verfahren nach Anspruch 22, **dadurch gekennzeichnet, dass** die Phyllosilicate mindestens ein Phyllosilicat enthalten, das aus der aus Glimmer, Talk, Gips, Kaolinit, Montmorillonit und Mischungen derselben bestehenden Gruppe ausgewählt ist.

24. Verfahren nach Anspruch 16, **dadurch gekennzeichnet, dass** die wässrige Schlichtzusammensetzung im wesentlichen frei von wasseraufnehmenden anorganischen festen Gleitmittelteilchen ist.

25. Verfahren nach einem der Ansprüche 1, 2 oder 3, **dadurch gekennzeichnet, dass** der Härtewert der anorganischen festen Gleitmittelteilchen kleiner als oder gleich dem Härtewert der mindestens einen Glasfaser ist.

26. Verfahren nach Anspruch 15, **dadurch gekennzeichnet, dass** die anorganischen festen Gleitmittelteilchen einen Mohs-Härtewert im Bereich von 1 bis 6 aufweisen.

27. Verfahren nach einem der Ansprüche 1, 2 oder 3, **dadurch gekennzeichnet, dass** die mittlere Größe der anorganischen Gleitmittelteilchen kleiner als 1000 *µ*m ist.

28. Verfahren nach einem der Ansprüche 1, 2 oder 3, **dadurch gekennzeichnet, dass** die anorganischen festen Gleitmittelteilchen wärmeleitend sind.

29. Verfahren nach einem der Ansprüche 1, 2 oder 3, **dadurch gekennzeichnet, dass** die anorganischen festen Gleitmittelteilchen elektrisch isolierend sind.

30. Verfahren nach einem der Ansprüche 1, 2 oder 3, **dadurch gekennzeichnet, dass** die anorganischen festen Gleitmittelteilchen 0,001 bis 99 Gew.-%, bezogen auf Gesamtfeststoffe der ersten wässrigen Schlicht- oder Beschichtungszusammensetzung, ausmachen.

31. Verfahren nach einem der Ansprüche 1, 2 oder 3, **dadurch gekennzeichnet, dass** die Schlichtzusammensetzung weniger als 20 Vol.-% Glasmaterialien enthält.

32. Verfahren nach einem der Ansprüche 1 bis 5, **dadurch gekennzeichnet, dass** die feste Oberfläche in Schritt (c) Oberflächenunebenheiten eines Teils einer Vorrichtung zum Konfektionieren von Textilerzeugnissen ist, die Oberflächenunebenheiten einen Härtewert aufweisen, der größer ist als ein Härtewert von Glasfasern des ersten Glasfaserstranges, und (d) Miteinanderverflechten des ersten Glasfaserstranges mit einem zweiten Faserstrang, um ein Textilerzeugnis auszubilden.

33. Verfahren nach Anspruch 32, **dadurch gekennzeichnet, dass** die Vorrichtung zum Konfektionieren von Textilerzeugnissen ausgewählt ist aus der Gruppe bestehend aus einem Webstuhl und einer maschenbildenden Vorrichtung.

## Revendications

1. Procédé pour empêcher l'usure par abrasion d'un paquet de fibres de verre comprenant au moins une fibre de verre par contact de glissement avec des aspérités de surface d'un objet solide, comprenant les étapes suivantes :
(a) l'application d'une couche primaire d'une première composition d'apprêt ou d'enrobage aqueuse comprenant une matière polymérique et des particules de lubrifiant solide inorganique sur au moins une partie d'une surface d'au moins une fibre de verre d'un paquet de fibres de verre;
(b) au moins le séchage partiel de la première composition d'apprêt ou d'enrobage aqueuse de la couche primaire pour former un paquet de fibres de verre apprêtées ayant un enrobage généralement uniforme de la composition d'apprêt ou d'enrobage aqueuse sur la partie de la surface d'au moins la fibre de verre; et
(c) le glissement d'au moins une partie du paquet de fibres de verre pour entrer en contact avec des aspérités de surface d'un objet solide, les aspérités de surface ayant une valeur de dureté qui est supérieure à une valeur de dureté d'au moins la fibre de verre, de telle sorte que l'usure par abrasion d'au moins la fibre de verre du paquet de fibres de verre en contact avec les aspérités de surface de l'objet solide soit empêchée par les particules de lubrifiant solide inorganique.

2. Procédé suivant la revendication 1, dans lequel la première composition d'apprêt ou d'enrobage aqueuse utilisée dans l'étape (a) comprend un agent de couplage de fibres de verre à la place d'une matière polymérique.

3. Procédé suivant la revendication 1, dans lequel la première composition d'apprêt ou d'enrobage aqueuse est appliquée sur au moins une partie de surfaces apprêtées d'au moins une fibre de verre d'un paquet de fibres de verre formant une couche principale dans l'étape (a).

4. Procédé pour empêcher l'usure par abrasion d'un paquet de fibres de verre comprenant au moins une fibre de verre apprêtée et enrobée secondairement par un contact de glissement avec des aspérités de surface d'un objet solide, comprenant les étapes suivantes :
(a) l'application dune couche principale comprenant des particules de lubrifiant solide inorganique lamellaires, non hydratables pulvérulentes sur au moins une partie dune surface apprêtée et revêtue secondairement d'au moins une fibre de verre d'un paquet de fibres de verre; et
(b) le glissement d'au moins une partie du paquet de fibres de verre pour entrer en contact avec des aspérités de surface d'un objet solide, les aspérités de surface ayant une valeur de dureté qui est supérieure à une valeur de dureté d'au moins la fibre de verre, de telle sorte que l'usure par abrasion d'au moins la fibre de verre du paquet de fibres de verre par contact avec les aspérités de surface de l'objet solide soit empêchée par les particules de lubrifiant solide inorganique.

5. Procédé suivant Tune ou l'autre des revendications 1 et 2, dans lequel la première composition d'apprêt ou d'enrobage aqueuse comprend des particules de nitrure de bore lamellaires, une matière filmogène de polyester thermodurcissable, de la polyvinyl pyrrolidone et un agent de couplage d'organosilane époxy-fonctionnel.

6. Procédé suivant Tune quelconque des revendications 1 à 5, dans lequel au moins la fibre de verre est choisie dans le groupe comprenant les fibres de verres E, les fibres de verre D, les fibres de verre S, les fibres de verre Q, les fibres de dérivés de verre E et leurs combinaisons.

7. Procédé suivant la revendication 6, dans lequel au moins la fibre de verre est une fibre de verre E.

8. Procédé suivant la revendication 7, dans lequel au moins la fibre de verre est une fibre de dérivé de verre E.

9. Procédé suivant l'une quelconque des revendications 1 à 5, dans lequel au moins une d'au moins la fibre de verre est formée dune matière pouvant être amenée à l'état de fibres choisie dans le groupe comprenant les matières inorganiques non vitreuses, les matières naturelles, les matières polymériques organiques et leurs combinaisons.

10. Procédé suivant la revendication 1, dans lequel la matière polymérique comprend au moins une matière choisie dans le groupe comprenant les matières thermodurcissables, les matières thermoplastiques et leurs mélanges.

11. Procédé suivant la revendication 10, dans laquelle la matière polymérique comprend au moins une matière thermodurcissable choisie dans le groupe comprenant les polyesters thermodurcissables, les esters vinyliques, les matières époxy, les matières phénoliques, les aminoplastes, les polyuréthannes thermodurcissables et leurs mélanges.

12. Procédé suivant la revendication 10, dans laquelle la matière polymérique comprend au moins une matière thermoplastique choisie dans le groupe comprenant les polymères vinyliques, les polyesters thermoplastiques, les polyoléfines, les polyamides, les polyuréthannes thermoplastiques, les polymères acryliques et leurs mélanges.

13. Procédé suivant la revendication 12, dans laquelle la matière thermoplastique est un polyester thermoplastique.

14. Procédé suivant la revendication 12, dans lequel la matière thermoplastique est une polyvinyl pyrrolidone.

15. Procédé suivant lane quelconque des revendications 1, 2 et 3, dans lequel les particules de lubrifiant solide inorganique ont une structure lamellaire.

16. Procédé suivant Tune quelconque des revendications 1, 2 et 3, dans lequel les particules de lubrifiant solide inorganique comprennent au moins une particule choisie dans le groupe comprenant les particules de lubrifiant solide inorganique non hydratables, les particules de lubrifiant solide inorganique hydratables et leurs mélanges.

17. Procédé suivant la revendication 16, dans lequel les particules de lubrifiant solide inorganique non hydratables comprennent au moins une particule choisie dans le groupe comprenant le graphite, le nitrure de bore, les dichalcogénures métalliques, l'iodure de cadmium, le sulfure d'argent et leurs mélanges.

18. Procédé suivant la revendication 17, dans lequel les particules de lubrifiant solide inorganique non hydratables comprennent au moins une particule choisie dans le groupe comprenant le nitrure de bore, les dichalcogénures métalliques, l'iodure de cadmium, le sulfure d'argent et leurs mélanges.

19. Procédé suivant la revendication 18, dans lequel les particules de lubrifiant solide inorganique non hydratables comprennent des particules de nitrure de bore de structure cristalline hexagonale.

20. Procédé suivant la revendication 18, dans lequel les particules de lubrifiant solide inorganique non hydratables comprennent au moins un dichalcogénure métallique choisi dans le groupe comprenant le disulfure de molybdène, le diséléniure de molybdène, le disulfure de tantale, le diséléniure de tantale, le disulfure de tungstène, le diséléniure de tungstène et leurs mélanges.

21. Procédé suivant la revendication 16, dans lequel les particules de lubrifiant solide inorganique non hydratables comprennent au moins une particule choisie dans le groupe comprenant l'indium, le thallium, l'étain, le cuivre, le zinc, l'or, l'argent, le carbonate de calcium, le fluorure de calcium, l'oxyde de zinc et leurs mélanges.

22. Procédé suivant la revendication 16, dans lequel les particules de lubrifiant solide inorganique hydratables comprennent des phyllosilicates.

23. Procédé suivant la revendication 22, dans lequel les phyllosilicates comprennent au moins un phyllosilicate choisi dans le groupe comprenant le mica, le talc, le gypse, la kaolinite, la montmorillonite et leurs mélanges.

24. Procédé suivant la revendication 16, dans lequel la composition d'apprêt aqueuse est essentiellement exempte de particules de lubrifiant solide inorganique hydratables.

25. Procédé suivant l'une quelconque des revendications 1, 2 et 3, dans lequel la valeur de dureté des particules de lubrifiant solide inorganique est inférieure ou égal à la valeur de dureté d'au moins une fibre de verre.

26. Procédé suivant la revendication 25, dans lequel les particules de lubrifiant solide inorganique ont une valeur de dureté de Mohs allant de 1 à 6.

27. Procédé suivant Tune quelconque des revendications 1, 2 et 3, dans lequel la taille moyenne des particules de lubrifiant inorganique est inférieure à 1.000 micromètres.

28. Procédé suivant Tune quelconque des revendications 1, 2 et 3, dans lequel les particuies de lubrifiant solide inorganique sont thermiquement conductrices.

29. Procédé suivant Tune quelconque des revendications 1, 2 et 3, dans lequel les particules de lubrifiant solide inorganique sont électriquement isolantes.

30. Procédé suivant Tune quelconque des revendications 1, 2 et 3, dans lequel les particules de lubrifiant solide inorganique comprennent 0,001 à 99 % en poids de la première composition d'apprêt ou d'enrobage aqueuse sur la base des matières solides totales.

31. Procédé suivant Tune quelconque des revendications 1, 2 et 3, dans lequel la composition d'apprêt comprend moins de 20 % en volume de matières vitreuses.

32. Procédé suivant Tune quelconque des revendications 1 à 5, dans lequel la surface du solide dans l'étape (c) est constituée d'aspérités de surface dune partie d'un dispositif d'assemblage de tissu, les aspérités de surface ayant une valeur de duleté qui est plus grande qu'une valeur de dureté des fibres de verre du premier paquet de fibres de verre, et (d) l'entrelacement du premier paquet de fibres de verre avec un second paquet de fibres de verre pour former un tissu.

33. Procédé suivant revendication 32, dans lequel le dispositif d'assemblage de tissu est choisi dans le groupe comprenant un métier à tisser et une machine à tricoter.
